(19) Europäisches Patentamt / European Patent Office / Office européen des brevets

(11) **EP 3 247 768 B1**

(12) **EUROPÄISCHE PATENTSCHRIFT**

(45) Veröffentlichungstag und Bekanntmachung des Hinweises auf die Patenterteilung:
**13.03.2019 Patentblatt 2019/11**

(21) Anmeldenummer: **16702348.0**

(22) Anmeldetag: **20.01.2016**

(51) Int Cl.:
***C09K 11/06*** *(2006.01)* ***H01L 51/50*** *(2006.01)*
***H01L 51/00*** *(2006.01)*

(86) Internationale Anmeldenummer:
**PCT/EP2016/051145**

(87) Internationale Veröffentlichungsnummer:
**WO 2016/116510 (28.07.2016 Gazette 2016/30)**

(54) **NAPHTHYL-SUBSTITUIERTE ORGANISCHE MOLEKÜLE ZUR VERWENDUNG IN OPTOELEKTRONISCHEN BAUELEMENTEN**

NAPHTHYL SUBSTITUTED ORGANIC MOLECULES FOR USE IN OPTOELECTRONIC COMPONENTS

MOLÉCULES ORGANIQUES SUBSTITUÉES PAR NAPHTHYL DESTINÉES À ÊTRE UTILISÉES DANS DES ÉLÉMENTS DE CONSTRUCTION OPTO-ÉLECTRONIQUES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.01.2015 EP 15151870**
**20.05.2015 EP 15168299**

(43) Veröffentlichungstag der Anmeldung:
**29.11.2017 Patentblatt 2017/48**


(73) Patentinhaber: **cynora GmbH**
**76646 Bruchsal (DE)**

(72) Erfinder:
- **AMBROSEK, David**
  **10437 Berlin (DE)**
- **DANZ, Michael**
  **76344 Eggenstein-Leopoldshafen (DE)**
- **FLÜGGE, Harald**
  **76135 Karlsruhe (DE)**
- **FRIEDRICHS, Jana**
  **76137 Karlsruhe (DE)**
- **GRAB, Tobias**
  **76133 Karlsruhe (DE)**
- **JACOB, Andreas**
  **30449 Hannover (DE)**
- **SEIFERMANN, Stefan**
  **77815 Brühl (DE)**
- **VOLZ, Daniel**
  **76137 Karlsruhe (DE)**
- **MYDLAK, Mathias**
  **76133 Karlsruhe (DE)**

(74) Vertreter: **Hoppe, Georg Johannes**
**Darani Anwaltskanzlei**
**Beuckestrasse 20**
**14163 Berlin (DE)**



(56) Entgegenhaltungen:
**WO-A1-2014/104315 WO-A1-2014/146750**
**WO-A2-2010/054183 DE-A1- 2 118 494**
**JP-A- 2011 153 276**

- **ANSUMAN BEJ ET AL: "Solvent free, phosphine free Pd-catalyzed annulations of aryl bromides with diarylacetylenes", RSC ADVANCES: AN INTERNATIONAL JOURNAL TO FURTHER THE CHEMICAL SCIENCES, Bd. 3, Nr. 36, 1. Januar 2013 (2013-01-01), Seite 15812, XP055222976, GB ISSN: 2046-2069, DOI: 10.1039/c3ra41924j**
- **REIKO NISHINO ET AL: "Investigation of the Carboxylate Position during the Acylation Reaction Catalyzed by Biaryl DMAP Derivatives with an Internal Carboxylate", ANGEWANDTE CHEMIE INTERNATIONAL EDITION, Bd. 52, Nr. 25, 6. Mai 2013 (2013-05-06), Seiten 6445-6449, XP055222969, DE ISSN: 1433-7851, DOI: 10.1002/anie.201300665**


Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- A J Boulton ET AL: "Furazans and furazan oxides. III. Acenaphtho[1,2-c]furazan", J. Org. Chem, 1. März 1973 (1973-03-01), Seiten 1054-1055, XP055261966, DOI: 10.1021/jo00945a043 Gefunden im Internet: URL:http://pubs.acs.org/doi/pdf/10.1021/jo00945a043 [gefunden am 2016-03-31]
- HIROKI UOYAMA ET AL: "Highly efficient organic light-emitting diodes from delayed fluorescence", NATURE, Bd. 492, Nr. 7428, 12. Dezember 2012 (2012-12-12), Seiten 234-238, XP055048388, ISSN: 0028-0836, DOI: 10.1038/nature11687

## Beschreibung

Die Erfindung betrifft rein organische Moleküle und deren Verwendung in organischen lichtemittierenden Dioden (OLEDs) und in anderen optoelektronischen Bauelementen.

## Stand der Technik

In den letzten Jahren hat sich die auf OLED (organische lichtemittierende Dioden) basierende Technik im Bereich Bildschirmtechnik etabliert, so dass nun die ersten hierauf aufbauenden kommerziellen Produkte erhältlich werden. Neben der Bildschirmtechnik eignen sich OLEDs auch für die Anwendung in flächiger Beleuchtungstechnik. Aus diesem Grund wird bezüglich der Entwicklung neuer Materialien intensive Forschung betrieben.

OLEDs sind in der Regel in Schichtenstrukturen realisiert, welche überwiegend aus organischen Materialien bestehen. Zum besseren Verständnis ist in Figur 1 ein vereinfachter Aufbau exemplarisch dargestellt. Herzstück solcher Bauteile ist die Emitterschicht, in der in der Regel emittierende Moleküle in einer Matrix eingebettet sind. In dieser Schicht treffen sich negative Ladungsträger (Elektronen) und positive Ladungsträger (Löcher), die zu sogenannten Exzitonen (= angeregte Zustände) rekombinieren. Die in den Exzitonen enthaltene Energie kann von den entsprechenden Emittern in Form von Licht abgegeben werden, wobei man in diesem Fall von Elektrolumineszenz spricht. Einen Überblick über die Funktion von OLEDs findet sich beispielsweise bei H. Yersin, Top. Curr. Chem. 2004, 241, 1 und H. Yersin, "Highly Efficient OLEDs with Phosphorescent Materials"; Wiley-VCH, Weinheim, Germany, 2008.

Seit den ersten Berichten bezüglich OLEDs (Tang et al. Appl. Phys. Lett. 1987, 51, 913) ist diese Technik besonders auf dem Gebiet der Emittermaterialien immer weiterentwickelt worden. Während die ersten Materialien, die auf rein organischen Molekülen beruhen, aufgrund von Spinstatistik maximal 25 % der Exzitonen in Licht umwandeln konnten, konnte durch die Verwendung von phosphoreszierenden Verbindungen dieses grundsätzliche Problem umgangen werden, so dass zumindest theoretisch alle Exzitonen in Licht umgewandelt werden können. Bei diesen Materialien handelt es sich in der Regel um Übergangsmetall-Komplexverbindungen, in denen das Metall aus der dritten Periode der Übergangsmetalle gewählt wird. Hierbei werden vorwiegend sehr teure Edelmetalle wie Iridium, Platin oder auch Gold eingesetzt. (Siehe dazu auch H. Yersin, Top. Curr. Chem. 2004, 241, 1 und M. A. Baldo, D. F. O'Brien, M. E. Thompson, S. R. Forrest, Phys. Rev. B 1999, 60, 14422). Neben den Kosten ist auch die Stabilität der Materialien zum Teil nachteilig für die Verwendung.

Eine neue Generation von OLEDs basiert auf der Ausnutzung von verzögerter Fluoreszenz (TADF: thermally activated delayed fluorescence oder auch singlet harvesting). Hierbei können beispielsweise Cu(I)-Komplexe verwendet werden, die aufgrund eines geringen Energieabstandes zwischen dem untersten Triplett-Zustand $T_1$ und dem darüberliegenden Singulett-Zustand $S_1$ ($\Delta E(S_1-T_1)$ Triplett-Exitonen thermisch in einen Singulett-Zustand rückbesetzen können. Neben der Verwendung von Übergangsmetallkomplexen können auch rein organische Moleküle diesen Effekt ausnutzen.

Einige solcher TADF-Materialien wurden bereits in ersten optoelektronischen Bauelementen eingesetzt. Die bisherigen Lösungen weisen jedoch Nachteile und Probleme auf: Die TADF-Materialien weisen in den optoelektronischen Bauelementen oftmals keine ausreichende Langzeitstabilität, keine ausreichende thermische oder keine ausreichende chemische Stabilität gegenüber Wasser und Sauerstoff auf. Außerdem sind nicht alle wichtigen Emissionsfarben verfügbar. Weiterhin sind einige TADF-Materialien nicht verdampfbar und dadurch für den Einsatz in kommerziellen optoelektronischen Bauteilen nicht geeignet. Auch weisen einige TADF-Materialien keine passenden Energielagen zu den weiteren im optoelektronischen Bauteil verwendeten Materialien (z.B. HOMO-Energien von TADF-Emittern von größer gleich -5,9 eV) auf. Nicht mit allen TADF-Materialien lassen sich ausreichend hohe Effizienzen der optoelektronischen Bauelemente bei hohen Stromdichten bzw. hohe Leuchtdichten erreichen. Weiterhin sind die Synthesen einiger TADF-Materialien aufwendig.

Aus Uoyama et al., Nature 492, 234-238 (2012) sind organische lichtemittierende Dioden (OLEDs) bekannt.

## Beschreibung

Die Beschreibung betrifft in einem Aspekt die Bereitstellung von organischen Molekülen, die eine Struktur der Formel 1 aufweisen oder eine Struktur der Formel 1 haben:

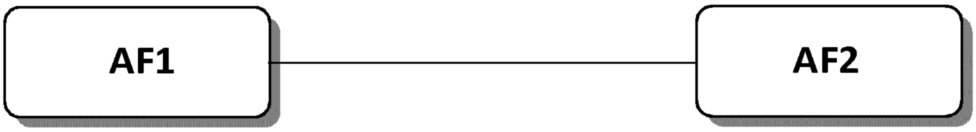


**Formel 1**

AF1 ist eine erste chemische Einheit, aufweisend ein konjugiertes System, insbesondere mindestens sechs in Konjugation stehende π-Elektronen (z. B. in Form mindestens eines aromatischen Systems);
AF2 ist eine zweite chemische Einheit, aufweisend ein konjugiertes System, insbesondere mindestens sechs in Konjugation stehende π-Elektronen (z. B. in Form mindestens eines aromatischen Systems);
AF1 ≠ AF2;
und wobei die chemische Einheit AF1 eine Struktur nach Formel 1a aufweist

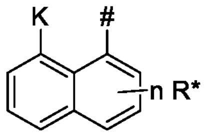

**Formel 1a**

und wobei insbesondere die andere chemische Einheit AF2 eine Struktur der Formel 3 aufweist oder ausgewählt ist aus einer der in Tabelle 1 aufgeführten Strukturen;
wobei in Formel 1a bedeutet:

# kennzeichnet die Position über die die Anbindung an die zweite Einheit AF2 erfolgt;

n ist eine ganzzahlige Zahl von 0 bis 6;

K = CN, $SO_2R^*$, SOR* oder $POR^*_2$;

R* ist bei jedem Auftreten unabhängig voneinander ausgewählt aus der Gruppe bestehend aus H, Deuterium, Phenyl, Naphthyl, $N(R^2)_2$, -CN, -NC, -SCN, $-CF_3$, $-NO_2$, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2-$, -C(=O)-, -C(=S)-, -C(=Se)-,-C=N-, -C(=O)O-, $-C(=O)N(R^3)-$, $-P(=O)(R^7)-$, $-As(=O)(R^7)-$, $-P(=S)(R^7)$, $-As(=S)(R^7)-$, -S(=O)-, $-S(=O)_2-$, $-NR^2-$, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R* auch miteinander ein mono- oder polycyclisches, aliphatisches, aromatisches und/oder benzoannelliertes Ringsystem bilden. In einer Ausführungsform ist das Ringsystem, das gebildet werden kann auf ein monozyklisches aliphatisches Ringsystem mit insgesamt fünf oder sechs Ringgliedern beschränkt.

$R^2$ ist bei jedem Auftreten unabhängig voneinander ausgewählt aus der Gruppe bestehend aus H, Deuterium, Phenyl, Naphthyl, $CF_3$, $C(=O)OR^3$, $C(=O)N(R^2)_2$, $Si(R^4)_3$, $C(=O)R^3$, $P(=O)(R^7)_2$, $As(=O)(R^7)_2$ $P(=S)(R^7)_2$, $As(=S)(R^7)_2$, $S(=O)R^3$, $S(=O)_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei

eine oder mehrere benachbarte $CH_2$-Gruppen durch -$R^9C=CR^9$-, -C≡C-, bzw. eine benachbarte $CH_2$-Gruppe durch -$Si(R^4)_2$-,-$Ge(R^4)_2$-, -$Sn(R^4)_2$, -C(=O)-, -C(=S)-, -C(=Se)-, -C=N-, -C(=O)O-, -C(=O)N($R^3$)-, -P(=O)($R^7$)-,-As(=O)($R^7$)-, -P(=S)($R^7$)-, -As(=S)($R^7$)-, -S(=O)-, -$S(=O)_2$-, -$NR^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden.

$R^3$ ist bei jedem Auftreten unabhängig voneinander ausgewählt aus der Gruppe bestehend aus H, Deuterium, Phenyl, Naphthyl, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden.

$R^4$ ist bei jedem Auftreten unabhängig voneinander ausgewählt aus der Gruppe bestehend aus H, Deuterium, Phenyl, Naphthyl, $N(R^2)_2$, CN, $CF_3$, OH, C(=O)O$R^3$, C(=O)N$(R^3)_2$, C(=O)$R^3$, P(=O)$(R^7)_2$, As(=O)$(R^7)_2$, P(=S)$(R^7)_2$, As(=S)$(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9C=CR^9$-, -C≡C-, bzw. eine benachbarte $CH_2$-Gruppe durch -$Si(R^4)_2$-, -$Ge(R^4)_2$-, -$Sn(R^4)_2$-,-C(=O)-, -C(=S)-, -C(=Se)-, -C=N-, -C(=O)O-, -C(=O)N($R^3$)-, -P(=O)($R^7$)-, -As(=O)($R^7$)-,-P(=S)($R^7$), -As(=S)($R^7$)-, -S(=O)-, -$S(=O)_2$-, -$NR^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^4$ auch miteinander ein mono- oder polycyclisches, aliphatisches, aromatisches und/oder benzoannelliertes Ringsystem bilden.

$R^5$ ist bei jedem Auftreten unabhängig voneinander ausgewählt aus der Gruppe bestehend aus Phenyl, Naphthyl, $CF_3$, C(=O)$R^3$, P(=O)$(R^7)_2$, As(=O)$(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9C=CR^9$-, -C≡C-, bzw. eine benachbarte $CH_2$-Gruppe durch -$Si(R^4)_2$-, -$Ge(R^4)_2$-, -$Sn(R^4)_2$,-C(=O)-, -C(=S)-, -C(=Se)-, -C=N-, -C(=O)O-, -C(=O)N($R^3$)-, -P(=O)($R^7$)-, -As(=O)($R^7$)-,-P(=S)($R^7$)-, -As(=S)($R^7$)-, -S(=O)-, -$S(=O)_2$-, -$NR^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^5$ auch miteinander ein mono- oder polycyclisches, aliphatisches, aromatisches und/oder benzoannelliertes Ringsystem bilden.

$R^6$ ist bei jedem Auftreten unabhängig voneinander ausgewählt aus der Gruppe bestehend aus Phenyl, Naphthyl, $CF_3$, $Si(R^4)_3$, C(=O)$R^3$, P(=O)$(R^7)_2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch-$R^9C=CR^9$-, -C≡C-, bzw. eine benachbarte $CH_2$-Gruppe durch-$Si(R^4)_2$-, -$Ge(R^4)_2$-, -$Sn(R^4)_2$,-C(=O)-, -C(=S)-, -C(=Se)-, -C=N-, -C(=O)O-, -C(=O)N($R^3$)-, -P(=O)($R^7$)-, -As(=O)($R^7$)-,-P(=S)($R^7$), -As(=S)($R^7$)-, -S(=O)-, -$S(=O)_2$-, -$NR^2$-, -O-, oder -S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste R* substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten $R^6$ auch miteinander ein mono- oder polycyclisches, aliphatisches, aromatisches und/oder benzoannelliertes

Ringsystem bilden.

$R^7$ ist bei jedem Auftreten unabhängig voneinander ausgewählt aus der Gruppe bestehend aus, Phenyl, Naphthyl, $N(R^2)_2$, CN, $CF_3$, $C(=O)OR^3$, $C(=O)N(R^3)_2$, $Si(R^4)_3$, $C(=O)R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-, -C=N-, -C(=O)O-,$-C(=O)N(R^3)-$, $-P(=O)(R^7)-$, $-As(=O)(R^7)-$, $-P(=S)(R^7)$, $-As(=S)(R^7)-$, -S(=O)-, $-S(=O)_2-$, $-NR^2-$,-O-, oder -S-ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^9$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^7$ auch miteinander ein mono- oder polycyclisches, aliphatisches, aromatisches und/oder benzoannelliertes Ringsystem bilden.

$R^8$ ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^8$ auch miteinander ein mono- oder polycyclisches, aliphatisches Ringsystem bilden.

$R^9$ ist bei jedem Auftreten unabhängig voneinander ausgewählt aus der Gruppe bestehend aus H, Deuterium, Phenyl, Naphthyl, $N(R^2)_2$, CN, $CF_3$, $NO_2$, OH, COOH, $C(=O)OR^3$, $C(=O)N(R^3)_2$, $Si(R^4)_3$, $B(OR^5)_2$, $C(=O)R^3$, $P(=O)(R^7)_2$, $P(=S)(R^7)_2$, $AS(=O)(R^7)_2$, $P(=S)(R^7)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^8$ substituiert sein kann, wobei eine oder mehrere nicht benachbarte $CH_2$-Gruppen durch $-R^3C=CR^3-$, -C≡C-, bzw. eine benachbarte $CH_2$-Gruppe durch $-Si(R^4)_2-$, $-Ge(R^4)_2-$, $-Sn(R^4)_2$, -C(=O)-, -C(=S)-, -C(=Se)-,-C=N-, -C(=O)O-, $-C(=O)N(R^3)-$, $-P(=O)(R^7)-$, $-As(=O)(R^7)-$, $-P(=S)(R^7)$, $-As(=S)(R^7)-$, -S(=O)-, $-S(=O)_2-$, $-NR^2-$, -O-, oder -S-ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^8$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^8$ substituiert sein kann, oder eine Kombination dieser Systeme; dabei können zwei oder mehrere dieser Substituenten $R^9$ auch miteinander ein mono- oder polycyclisches, aliphatisches, aromatisches und/oder benzoannelliertes Ringsystem bilden.

Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind insbesondere N, O, und S. Werden in der Beschreibung der vorliegenden Erfindung davon abweichende Definitionen angegeben, beispielsweise bezüglich der Zahl der aromatischen Ringatome oder der enthaltenen Heteroatome, so gelten diese abweichenden Definitionen.

Dabei wird unter einer Arylgruppe bzw. Heteroarylgruppe ein einfacher aromatischer Cyclus, also Benzol, bzw. ein einfacher heteroaromatischer Cyclus, beispielsweise Pyridin, Pyrimidin oder Thiophen, oder ein heteroaromatischer Polycyclus, beispielsweise Napthalin, Phenanthren, Chinolin oder Carbazol verstanden. Ein kondensierter (annelierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen; Pyrrol, Indol, Isoindol, Carbazol, Pyridin, Chinolin, Isochinolin, Acridin, Phenanthridin, Benzo-5,6-chinolin, Isochinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benztriazol, 1,2,3-Oxadiazol, 1,2,4-Oxadiazol, 1,2,5-Oxadiazol, 1,2,3,4-Tetrazin, Purin, Pteridin, Indolizin und Benzothiadiazol.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind insbsondere ausgewählt aus, N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (insbesondere weniger als 10% der verschiedenen Atome), wie z.B. ein sp3-hybridisiertes C-, Si-, oder N-Atom, ein sp2-hybridisiertes C-, N- oder O-Atom oder ein sp-hybridisiertes C-Atom, verbunden sein können. So sollen beispielsweise auch Systeme wie 9,9'-Diarylfluoren, Triarylamin, Diarylether, Stilben etc. als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Aryl- oder Heteroarylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5 bis 60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Napthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyarzinimidazol, Chinoxalinimidazol, Oxazol, Benzoxazol, Napthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,2,3 Oxadiazol, 1,2,3-Thiadiazol, 1,2,5-Thiadiazol, 1,3,4-Thiadiazol, 1,3,5-Triazin, 1,2,4-Triazin, 1,2,3-Triazin, Tetrazol, 1,2,3,5-Tetrazin, 1,2,3,4-Tetrazin, Purin, Pteridin, Indolizin und Benzothiadiazol oder Kombinationen dieser Gruppen.

Die Anbindung der chemischen Einheiten AF1 und AF2 aneinander erfolgt jeweils über die mit ‚# gekennzeichnete Position oder über die mit Kleinbuchstaben bezeichneten Positionen der einzelnen AF (siehe Formel 1a und Tabelle 1).

Die Einheit AF2 weist im Vergleich zu AF1 immer einen betragsmäßig niedrigeren HOMO-Zahlenwert auf (und damit auch entsprechend einen betragsmäßig niedrigeren LUMO-Zahlenwert) als AF2 ($|E_{HOMO}(AF2)| < |E_{HOMO}(AF1)|$ und $|E_{LUMO}(AF2)| < |E_{LUMO}(AF1)|$);

Durch die an das Naphthalin angeknüpften Substituenten K in peri-Position zur Einheit AF2 stehen die beiden $\pi$-Systeme von AF1 und AF2 durch Verdrillung nicht in Konjugation, sind aber dennoch in räumlicher Nähe fixiert und zudem HOMO und LUMO auf separaten Molekülteilen lokalisiert.

In einer Ausführungsform sind die chemischen Einheiten AF1 und AF2 derart miteinander verknüpft, dass die elektronische Kommunikation zwischen ihnen unterbrochen wird. Diese Unterbrechung ist durch eine Lokalisierung der Grenzorbitale HOMO und LUMO auf separaten Molekülteilen gekennzeichnet, sodass ein Charge-Transfer Übergang ermöglicht wird.

Die elektronische Kommunikation zwischen den zwei chemischen Einheiten AF1 und AF2 über konjugierte Bindungen ist unterbrochen, wenn die Grenzorbitale HOMO und LUMO auf separaten Molekülteilen lokalisiert sind, sodass ein Charge-Transfer Übergang ermöglicht wird. Die Lokalisierung der Grenzorbitale HOMO oder LUMO wird dabei mithilfe der Dichtefunktionaltheorie (DFT) mit dem BP86-Funktional (Becke, A. D. Phys. Rev. A1988, 38, 3098-3100; Perdew, J. P. Phys. Rev. B1986, 33, 8822-8827) visualisiert: Aus der Einelektronen-Wellenfunktion wird die Einelektronendichte durch Quadrieren berechnet und über den Raum integriert, den der untersuchte Molekülteil einnimmt. Dieser Raum kann aus den Atomkoordinaten und den van-der-Waals-Radien der Atome bestimmt werden. Die resultierende Zahl entspricht dem Anteil des Orbitals auf dem Molekülteil. Eine mehrheitliche Trennung der Grenzorbitale entspricht dabei einem Überlappungsparameter O im Bereich 0.1-20%, um einen Charge-Transfer Übergang zu ermöglichen. Der Überlappungsparameter O zwischen der HOMO-Wellenfunktion $\phi_a$ und der der LUMO-Wellenfunktion $\phi_b$ ergibt sich aus dem Integral über den gesamten Raum über den jeweils kleineren Wert der quadrierten Wellenfunktion:

$$O = \int \rho \ \mathrm{d}\tau \text{ mit } \rho = \begin{cases} \varphi_a^2, \text{ wenn } |\varphi_a| < |\varphi_b| \\ \varphi_b^2, \text{ wenn } |\varphi_a| \geq |\varphi_b| \end{cases}$$

In einer Ausführungsform zeichnen sich die organischen Moleküle dadurch aus, dass

- die Differenz der Energie des HOMO der zweiten chemischen Einheit AF2 und der Energie des HOMO der ersten chemischen Einheit AF1 > 0,8 eV ist (Δ HOMO = HOMO(AF2) - HOMO(AF1) > 0,8 eV);
- die Differenz der Energie des LUMO der zweiten chemischen Einheit AF2 und der Energie des LUMO der ersten chemischen Einheit AF1 > 0,8 eV ist (Δ LUMO = LUMO(AF2) - LUMO(AF1) > 0,8 eV); und/oder
- die Differenz der Energie des LUMO der ersten chemischen Einheit AF1 und der Energie des HOMO der zweiten chemischen Einheit AF2 > 0,9 eV ist (Δ Gap = LUMO (AF1) - HOMO(AF2)> 0,9 eV).

Dabei werden die Energiewerte HOMO(AF1), HOMO(AF2), LUMO(AF1), LUMO(AF2) mithilfe der Dichtefunktionaltheorie (DFT) berechnet, wobei die Anknüpfungspositionen der ambifunktionalen Einheiten mit einem Wasserstoffatom entsprechend ihrer chemischen Valenzen abgesättigt werden. Die angegebenen Grenzen beziehen sich auf Orbitalenergien in der Einheit eV, die mit dem BP86-Funktional berechnet werden (Becke, A. D. Phys. Rev. A1988, 38, 3098-3100; Perdew, J. P. Phys. Rev. B1986, 33, 8822-8827).

In einer Ausführungsform der Beschreibung weisen die organischen Moleküle eine Struktur der Formel 2 auf oder haben eine Struktur der Formel 2, wobei die bei Formel 1 und 1a angegebenen Definitionen gelten

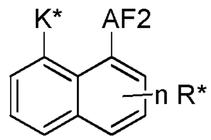

K* = CN, $SO_2R^*$

**Formel 2**

Entsprechend ergibt sich für AF1 eine Struktur nach Unterformel 2, wobei die gewellte Linie die Anknüpfungsstelle an AF2 darstellt:

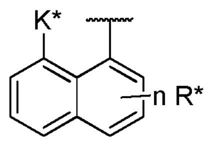

K* = CN, $SO_2R^*$

**Unterformel 2**

In einer Ausführungsform der Beschreibung sind die organischen Moleküle ausgewählt aus Formeln 2a-2d oder haben eine Struktur der Formel 2a-2d:

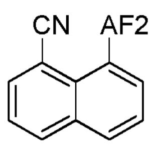 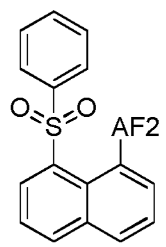 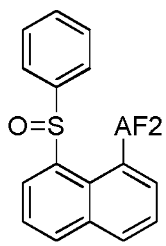 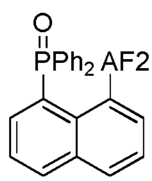

**Formel 2a** **Formel2b** **Formel 2c** **Formel 2d**

Die Beschreibung umfasst organische Moleküle, die sich aus einer Kombination der in Formel 1a bzw. Unterformel 2 gezeigten chemischen Gruppen und AF2 ergibt.

**Tabelle 1:** Auflistung von zweiten chemischen Einheiten AF2.

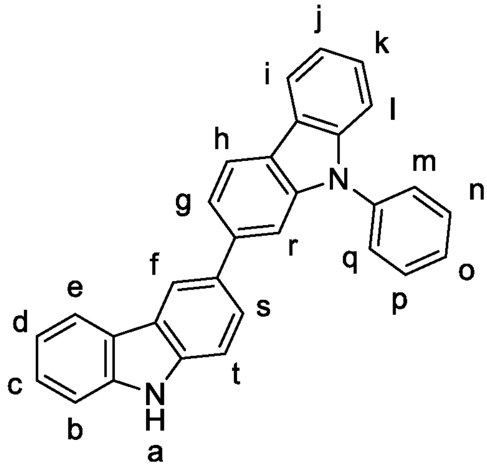

1

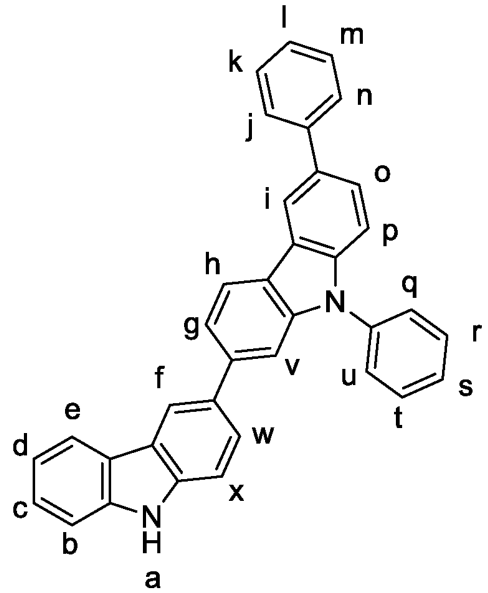

2

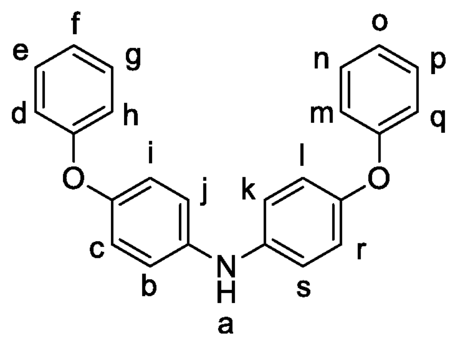

3

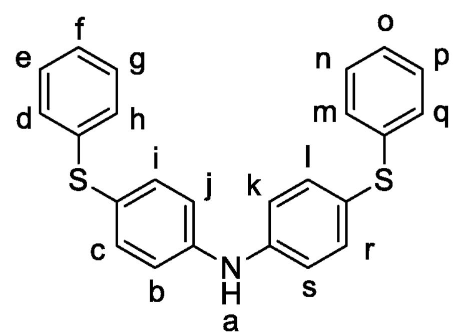

4

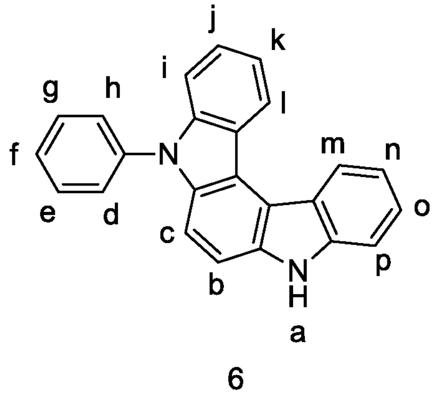

6

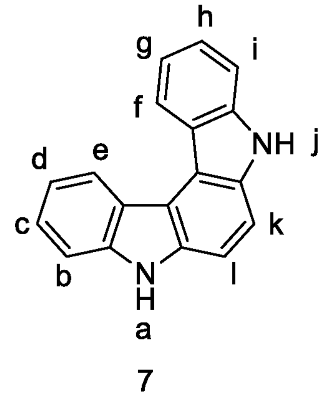

7

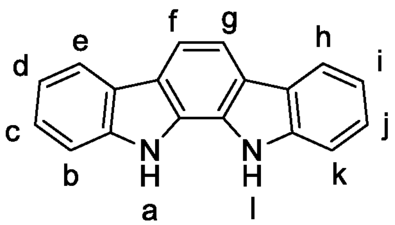

8

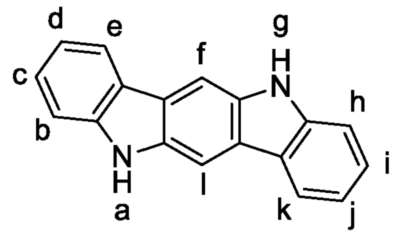

10

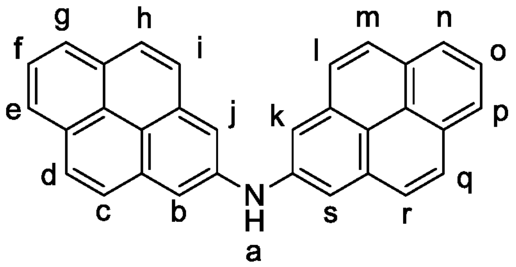

11

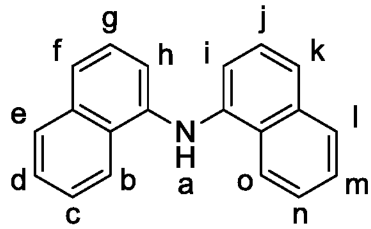

12

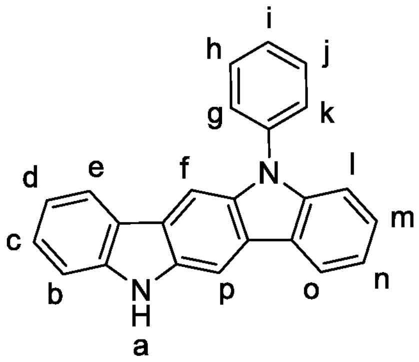

24

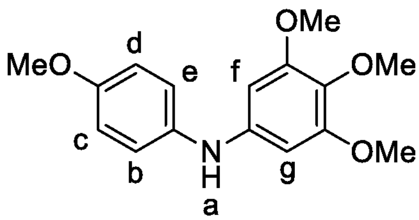

26

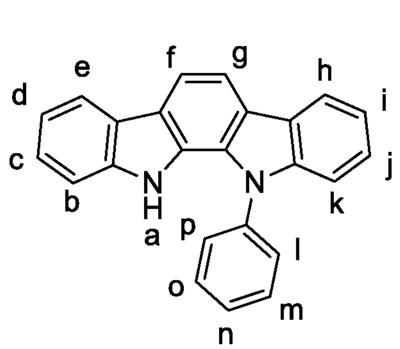

21

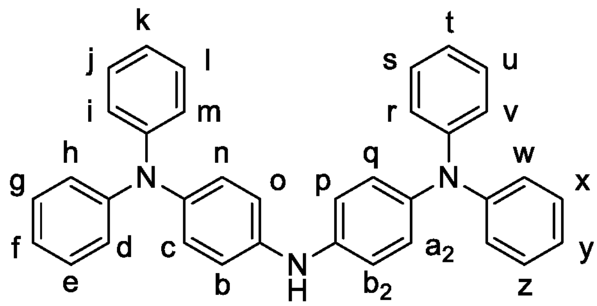

22

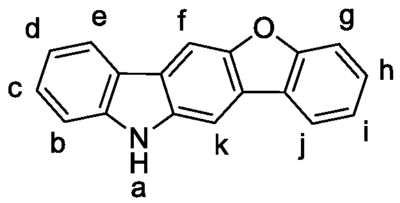

30

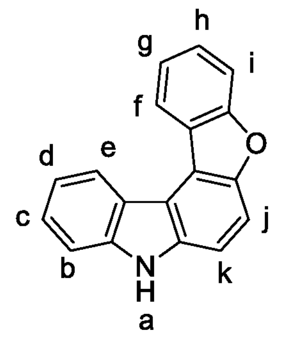

31

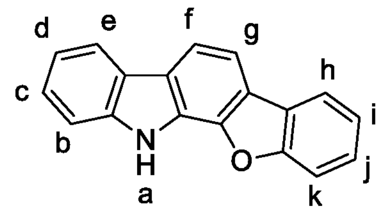

32

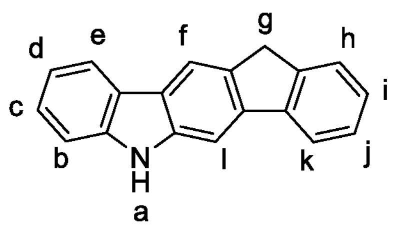

33

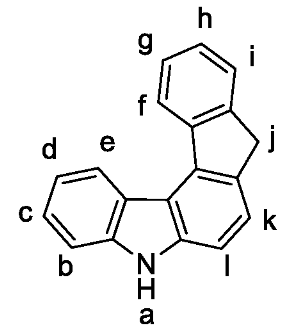

34

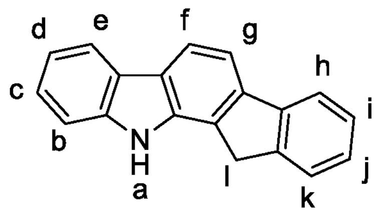

35

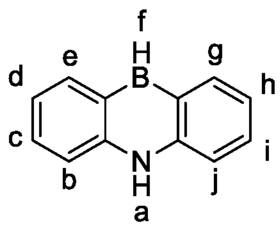

38

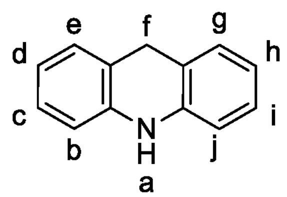

39

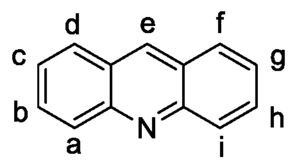

40

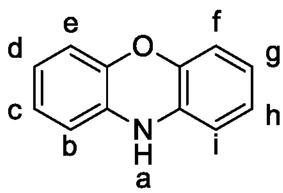

41

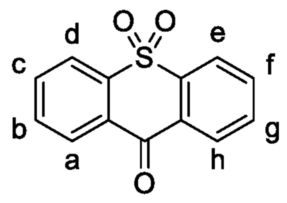

43

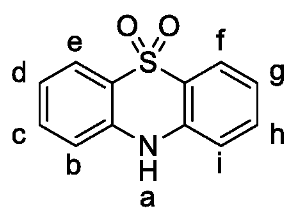

44

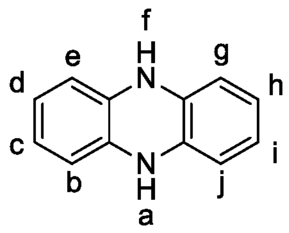

49

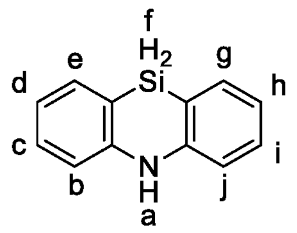

53

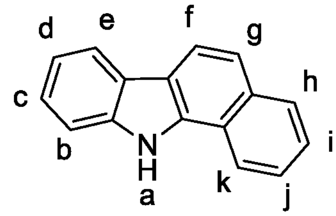

54

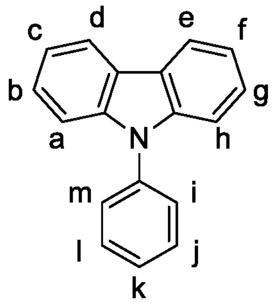

55

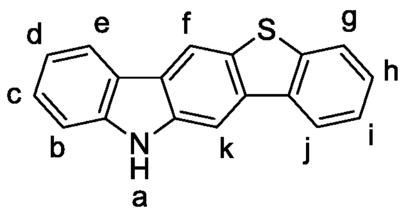

58

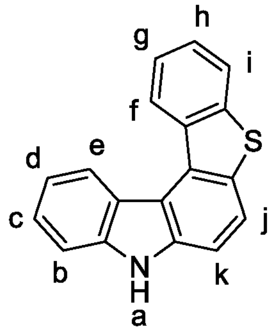

59

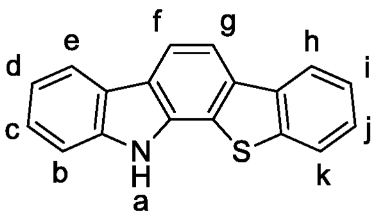

60

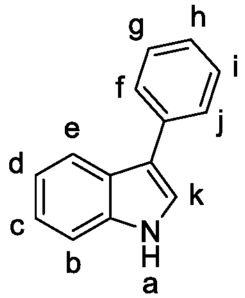

63

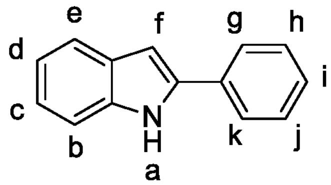

64

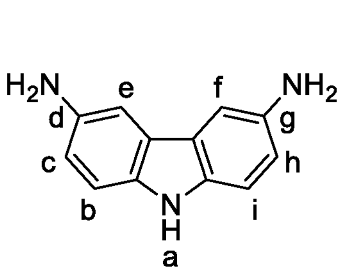

66

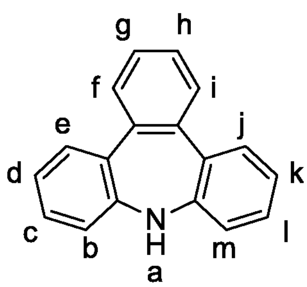

71

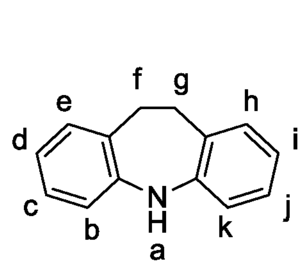

72

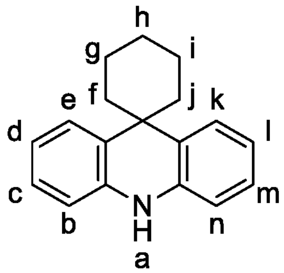

73

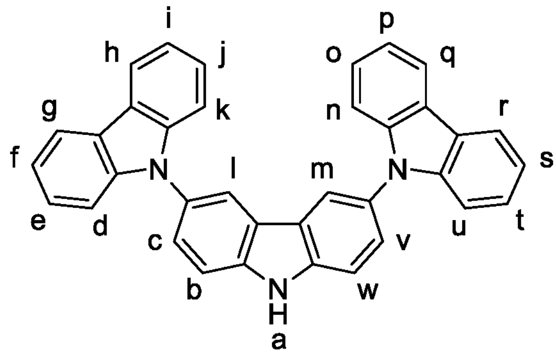

74

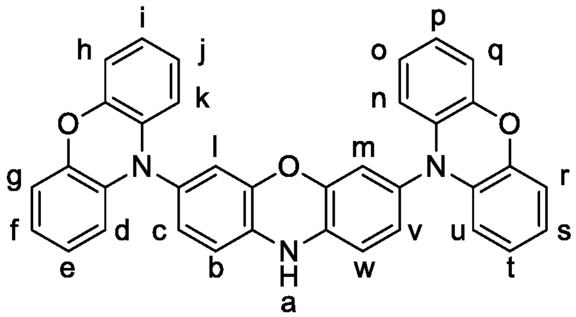

75

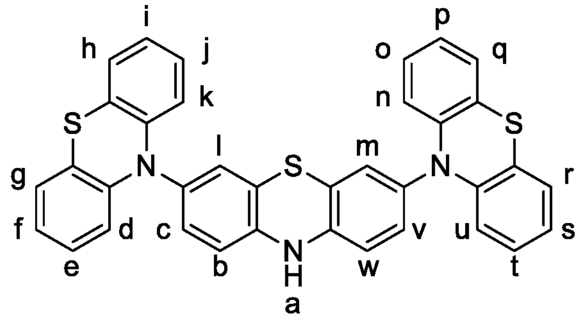

76

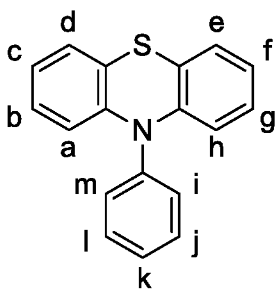

77

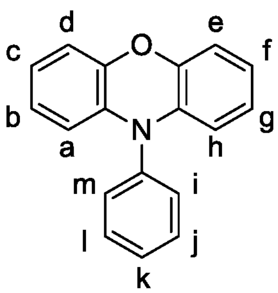

78

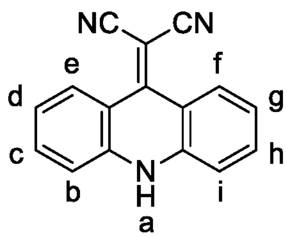

82

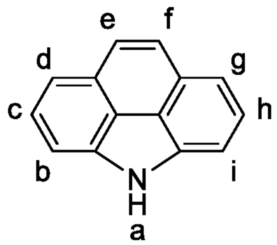

88

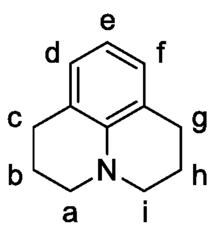

91

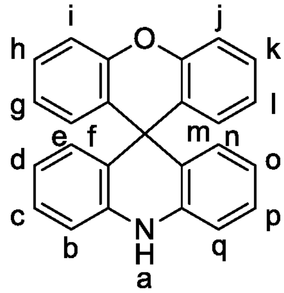

94

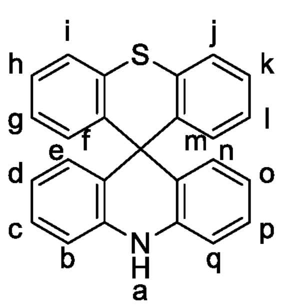

95

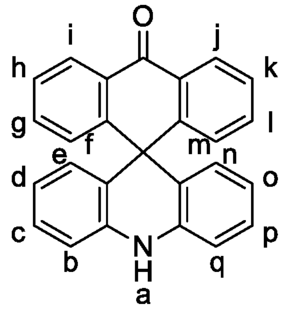

96

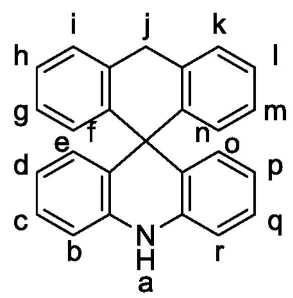

97

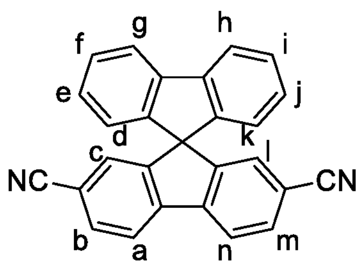

101

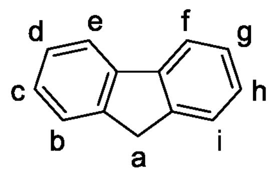

106

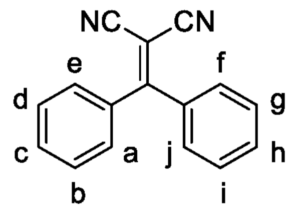

109

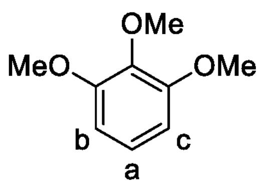

120

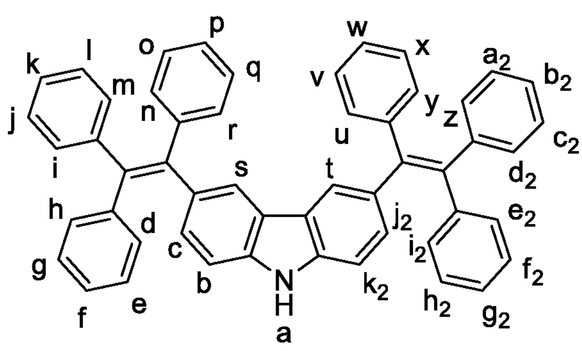

124

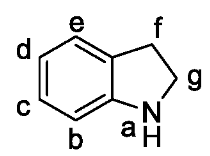

128

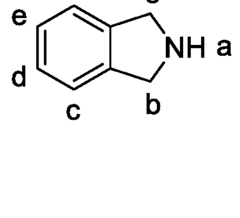

129

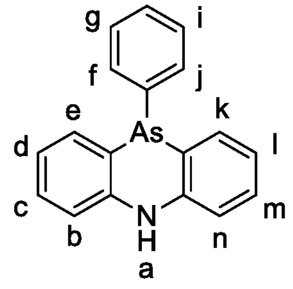

149

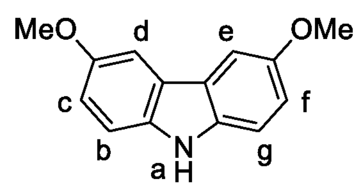

199

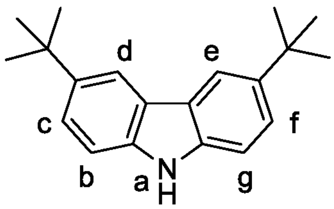

200

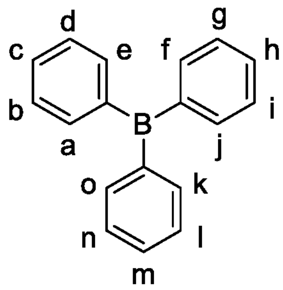

213

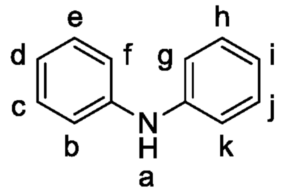

223

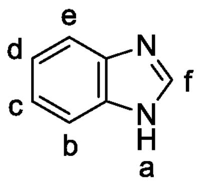

239

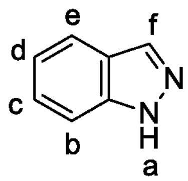

240

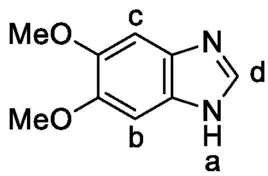

242

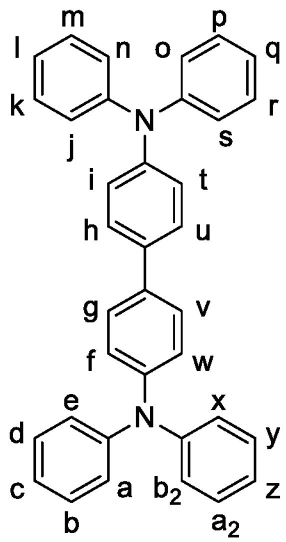

278

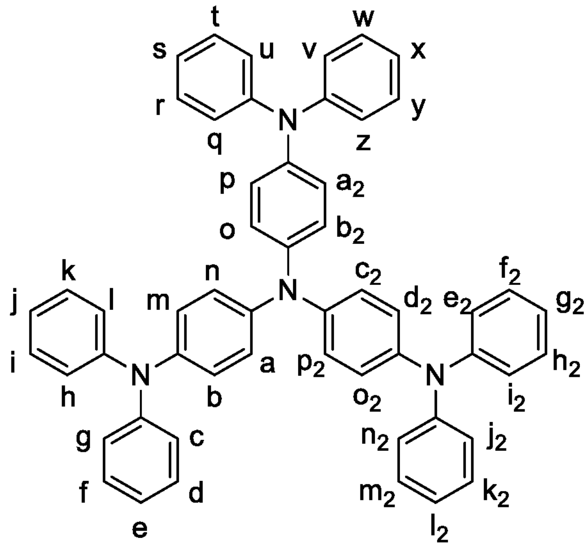

281

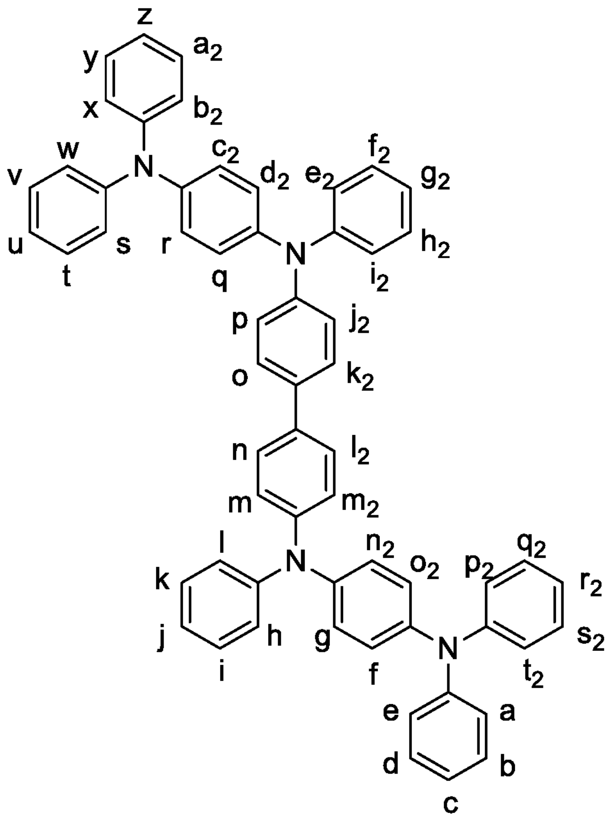

283

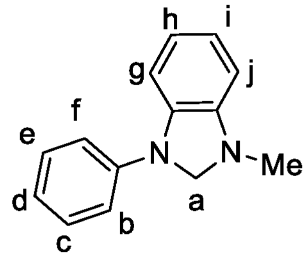

314

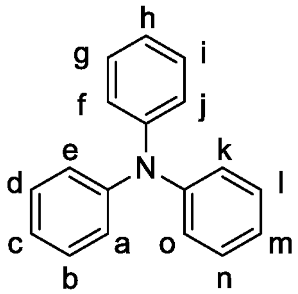

317

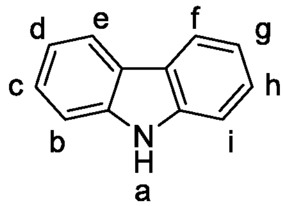

328

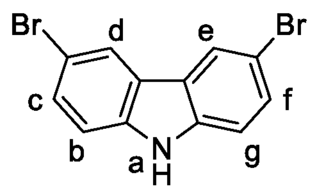

330

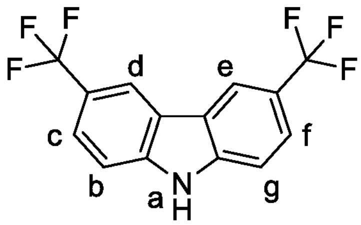

331

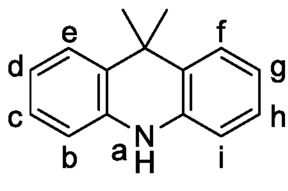

337

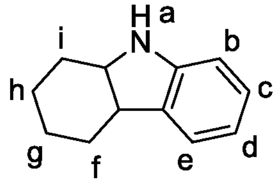

339

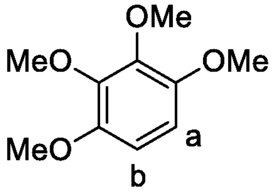

344

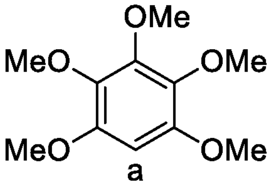

345

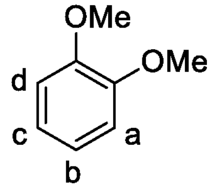

346

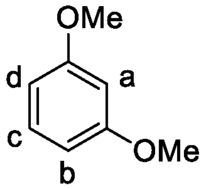

347

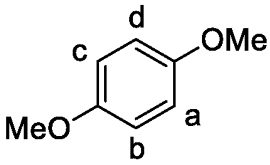

348

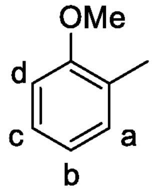

349

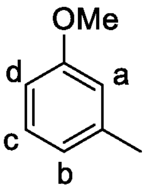

350

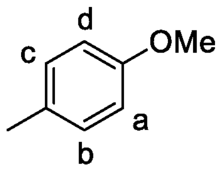

351

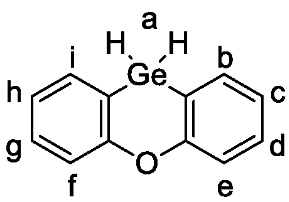

352

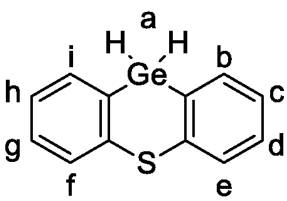

353

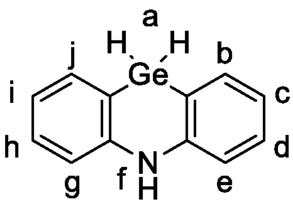

354

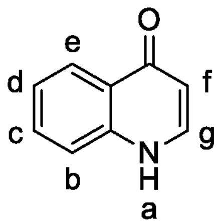

360

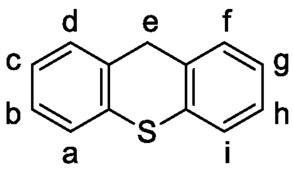

366

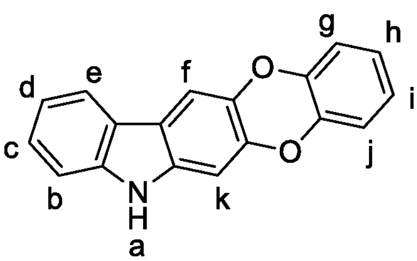

377

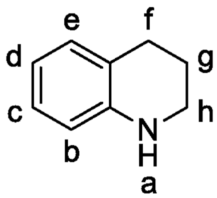

383

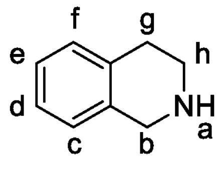

384

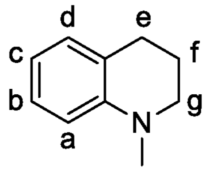

387

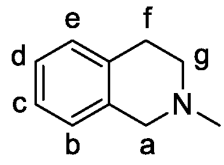

388

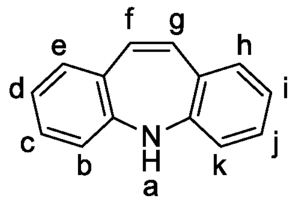

400

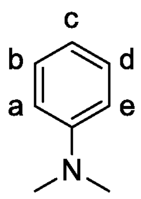

404

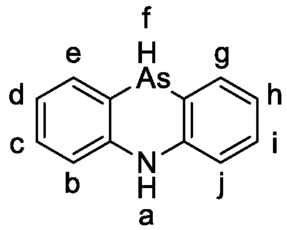

405

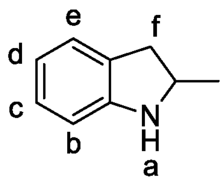

406

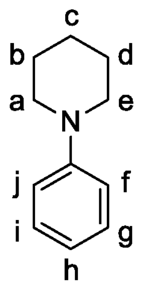

407

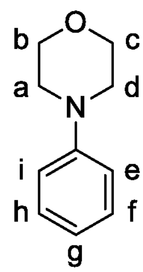

408

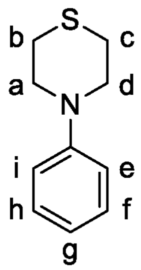

409

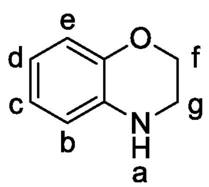

410

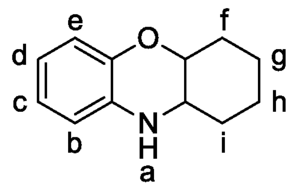

411

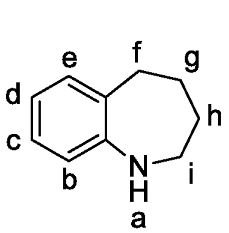

412

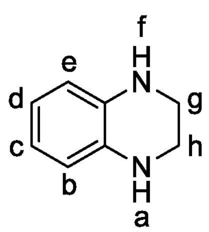

413

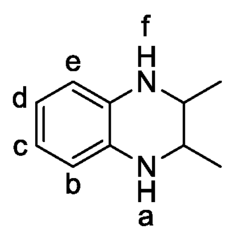

414

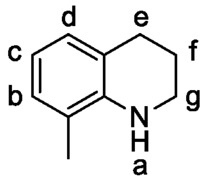

417

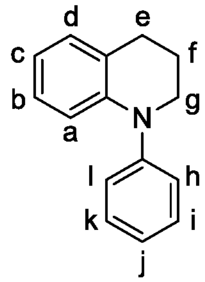

418

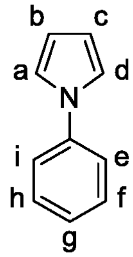

421

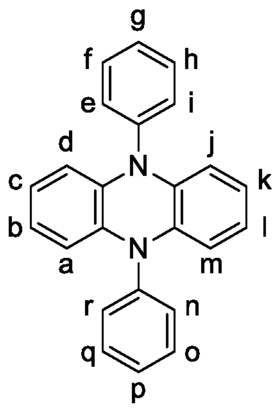

425

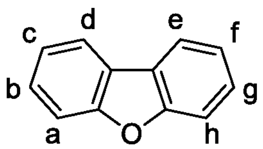

432

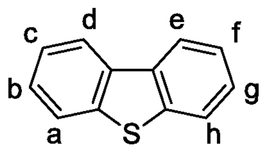

433

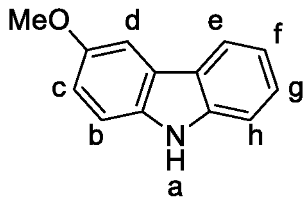

436

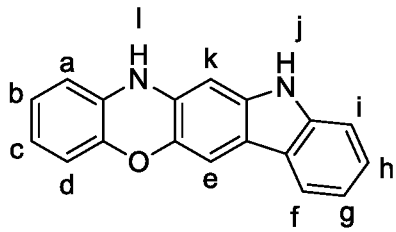

477

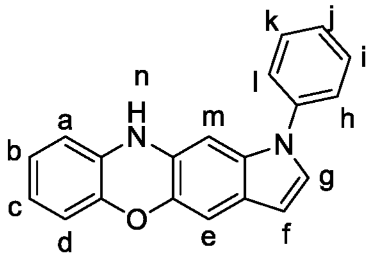

478

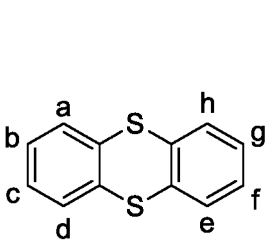

480

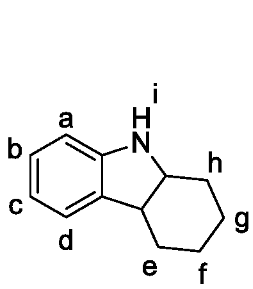

481

In Tabelle 1 sind mögliche Anknüpfungspositionen an die chemische Einheit AF1 mit Kleinbuchstaben a bis z bezeichnet. Jede aromatische C-H und N-H Bindung ist optional mit einem löslichkeitsvermittelnden und/oder einem die Polymerisierbarkeit ermöglichenden Rest R substituiert.

In einer Ausführungsform der Beschreibung weist die Einheit AF2 eine Struktur der Formel 3 auf oder hat eine Struktur der Formel 3

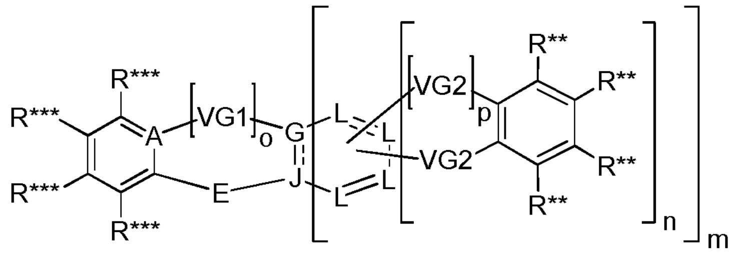

**Formel 3**

wobei gilt:

m ist 0 oder 1;

n ist 0 oder 1, wobei bei m = 0 immer auch n = 0 ist;

o ist 0 oder 1;

p ist 0 oder 1;

A ist CR*** wenn o = 0, ansonsten C;

VG1 = verbrückende Gruppe, ist ausgewählt aus der Gruppe bestehend aus

- NR**, CR**$_2$, O, S und einer C-C-Einfachbindung; oder
- NR**, CR**$_2$, O, S, einer C-C-Einfachbindung, BR**, AsR**, SiR**$_2$, GeR**$_2$,

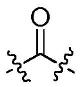, 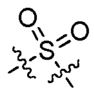, 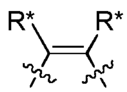, 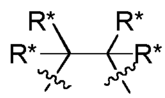, 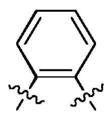, 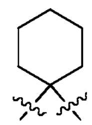, 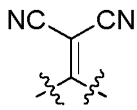, 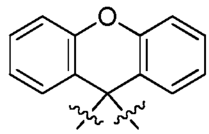,

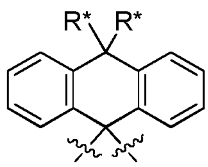, 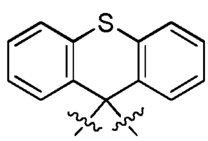, und 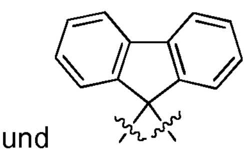,

wenn m = 1 und gleichzeitig n = 0;

VG2 = verbrückende Gruppe ist bei jedem Auftreten unabhängig voneinander ausgewählt aus der Gruppe bestehend aus CR**$_2$, NR**, O, S und einer C-C-Einfachbindung, wobei nicht zwei Einheiten VG2 gleichzeitig gleich einer C-C-Einfachbindung sind;

E ist NR**,

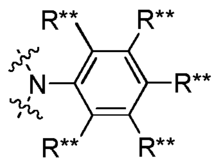,

O oder S;

G ist C wenn o = 1 und gleichzeitig m = 1;G ist CR** wenn o = 0 und gleichzeitig m = 1; G ist CR** oder $CR^{**}_2$, wenn o = 1 und gleichzeitig m = 0; G ist R* wenn o = 0 und gleichzeitig m = 0; G ist CR**, $CR^{**}_2$, N oder NR* wenn m = 0 und gleichzeitig VG1 eine C-C-Einfachbindung ist;

J ist C wenn m = 1; J ist CR**, $CR^{**}_2$ oder NR** wenn m = 0;

L ist CR*** wenn n = 0; L ist CR** oder C (bei kovalenter Bindung zu VG2) wenn n = 1;

R*** ist R** oder ist ausgewählt aus den folgenden Einheiten, wobei maximal zwei der Reste R*** gleichzeitig gleich einer der folgenden Einheiten sind:

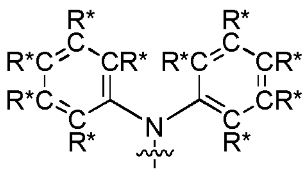, 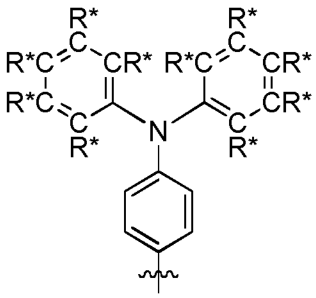, 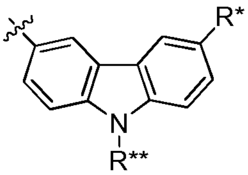, 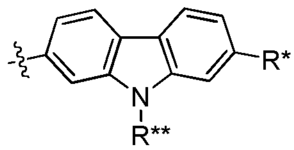,

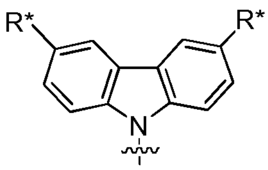, 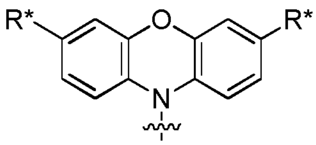, 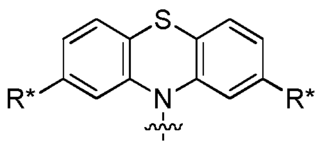,

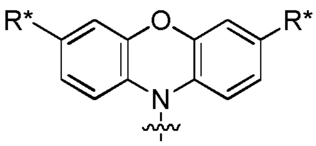, 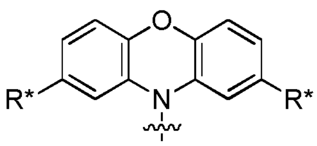;

R** ist bei jedem Auftreten unabhängig voneinander ein Rest R* und markiert eine Anknüpfungsstelle an eine chemische Einheit AF1, wobei genau ein R** eine Anknüpfungsstelle an die chemische Einheit AF1 ist.

R* ist wie bei Formel 1 definiert.

In einer weiteren Ausführungsform der Beschreibung weist die Einheit AF2 eine Struktur der Formel 4 auf oder hat eine Struktur der Formel 4

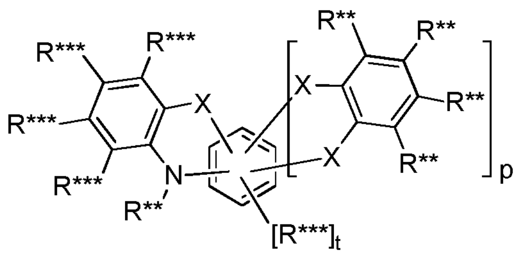

**Formel 4**

wobei in Formel 4 bedeutet:

p ist 0 oder 1;

t = 4 - 2p;

X ist $CR^{**}_2$, NR**, Sauerstoff, Schwefel oder eine direkte Bindung, wobei maximal zwei Platzhalter X gleichzeitig eine direkte Bindung sind, wobei diese nicht Bestandteil desselben Rings sind;

und im Übrigen die für Formel 3 gegebenen Definitionen gelten.

In einer weiteren Ausführungsform der Beschreibung weist die Einheit AF2 des organischen Moleküls eine Struktur der Formel 4A1-4A7 auf oder hat eine Struktur der Formel 4A1-4A7;

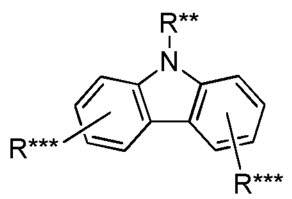

**Formel 4A1**

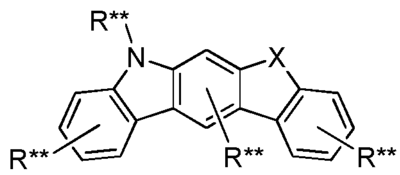

**Formel 4A2**

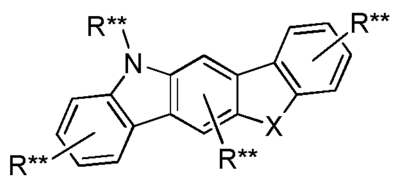

**Formel 4A3**

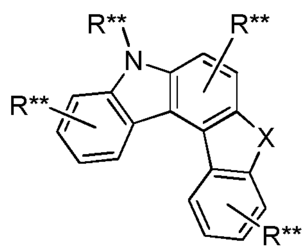

**Formel 4A4**

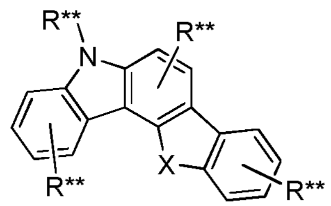

**Formel 4A5**

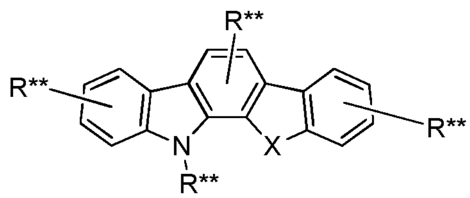

**Formel 4A6**

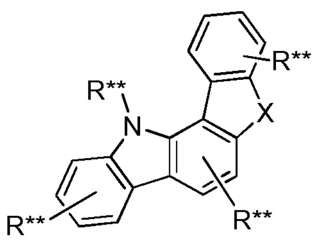

**Formel 4A7**

wobei in Formel 4A1-4A7 gilt:

X ist $C(R^{**})_2$, $NR^{**}$, Sauerstoff oder Schwefel;

und im Übrigen die für Formel 3 gegebenen Definitionen gelten.

In einer weiteren Ausführungsform der Beschreibung weist das organische Molekül eine Struktur der Formel 5 auf oder hat eine Struktur der Formel 5;

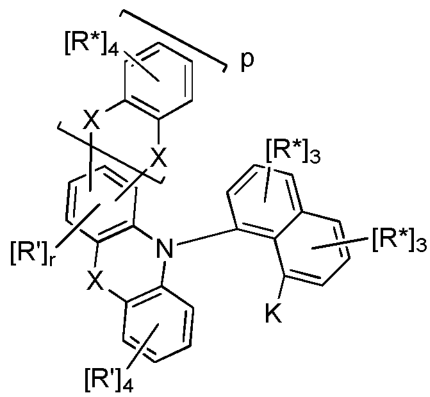

**Formel 5**

wobei in Formel 5 bedeutet:

p ist 0 oder 1;

r = 4 - 2p

X ist $CR^*_2$, $NR^*$, Sauerstoff, Schwefel, eine direkte Bindung, wobei maximal zwei Platzhalter X gleichzeitig eine direkte Bindung sind, wobei diese nicht Bestandteil desselben Rings sind;

K = CN, $SO_2R^*$, $SOR^*$, $POR^*_2$;

R' ist R* oder ist ausgewählt aus den folgenden Einheiten, wobei maximal zwei der Reste R' gleichzeitig gleich einer der folgenden Einheiten sind:

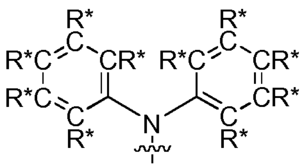 , 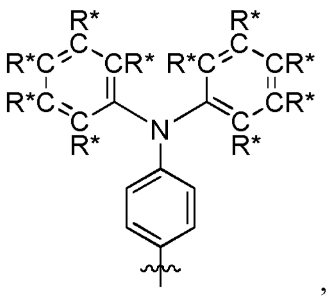 , 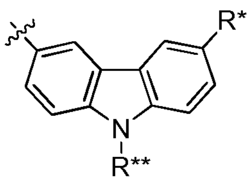 , 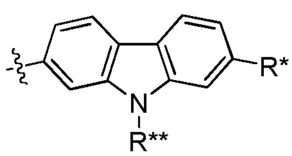 ,

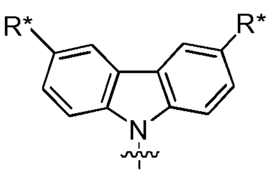 , 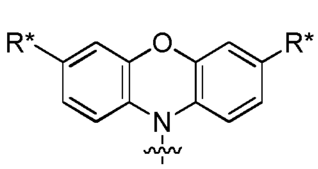 , 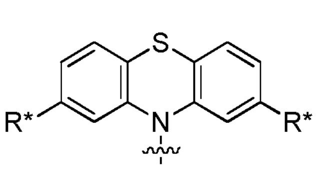 ,

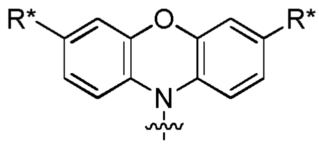,
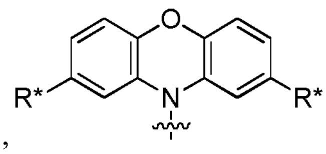;

und im Übrigen die für Formel 3 gegebenen Definitionen gelten.

In einer weiteren Ausführungsform der Beschreibung weist das organische Molekül eine Struktur der Formel 6 auf oder hat eine Struktur der Formel 6;

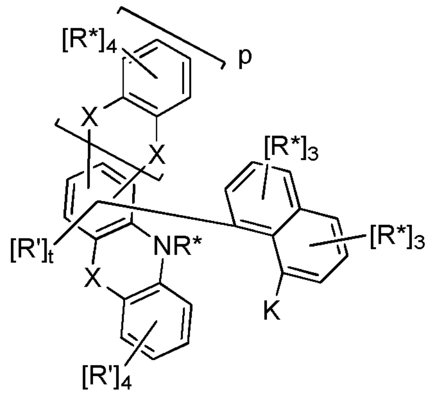

**Formel 6**

wobei in Formel 6 bedeutet:

p ist 0 oder 1;

t = 3 - 2p

X ist $CR^*_2$, NR*, Sauerstoff, Schwefel oder eine direkte Bindung, wobei maximal zwei Platzhalter X gleichzeitig eine direkte Bindung sind, wobei diese nicht Bestandteil desselben Rings sind;

K = CN, $SO_2R^*$, SOR* oder $POR^*_2$;

R' ist R* oder ist ausgewählt aus den folgenden Einheiten, wobei maximal zwei der Reste R' gleichzeitig gleich einer der folgenden Einheiten sind:

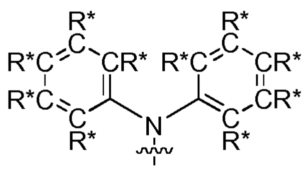, 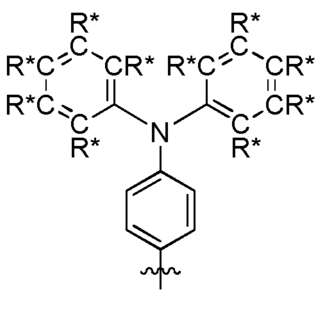, 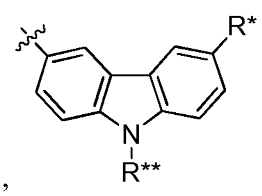, 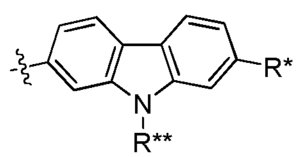,

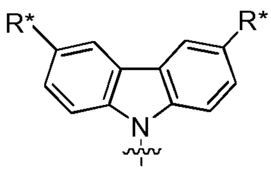, 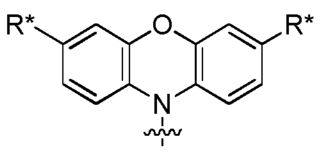, 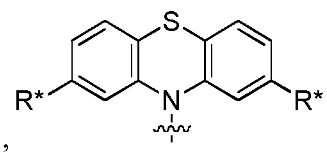,

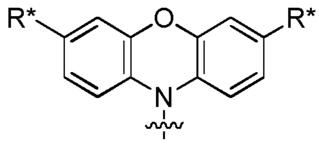
,
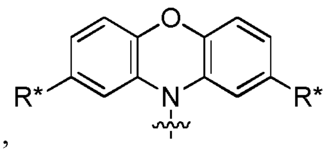
;

und im Übrigen die für Formel 3 gegebenen Definitionen gelten.

In einer Ausführungsform der Beschreibung ist AF1 aus den in Tabelle 2 angegebenen Verbindungen ausgewählt.

**Tabelle 2:** Chemische Einheiten AF1, wobei # die Anknüpfungsposition für die chemische Einheit AF2 kennzeichnet.

| | | | |
|---|---|---|---|
| 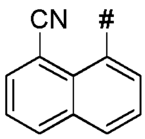 | 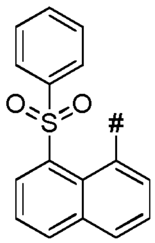 | 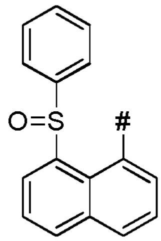 | 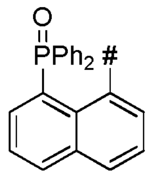 |
| 244 | 245 | 276 | 318 |

In Tabelle 3 sind Beispiele für erfindungsgemäße Verbindungen angegeben. In Tabelle 3a sind Beispiel für organische Moleküle gemäß der Beschreibung angegeben.

**Tabelle 3:** Erfindungsgemäße organische Moleküle (AF1-AF2). Die Benennung der Moleküle enthält links die Komponente AF1, die an eine zweite chemische Gruppe AF2.

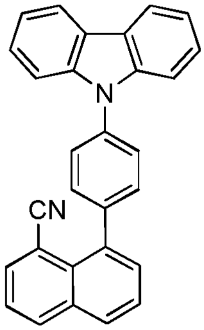

244—55

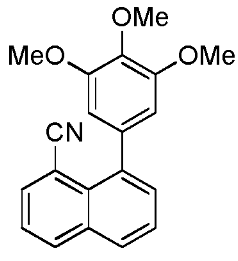

244—120

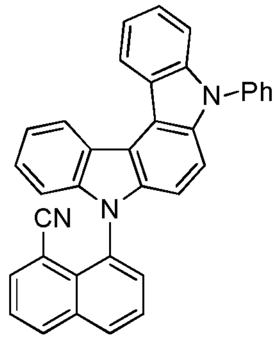

244—6

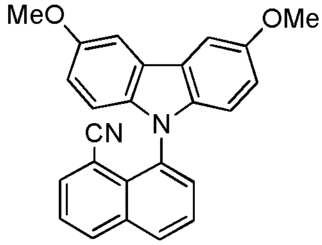

244—199

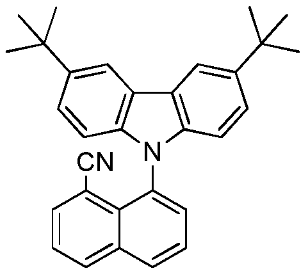

244—200

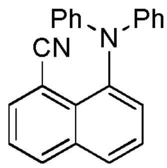

244—223

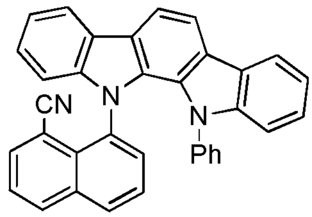

244—21

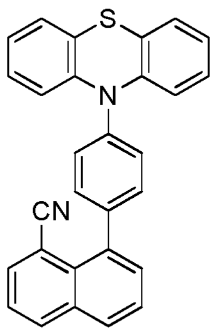

244—77

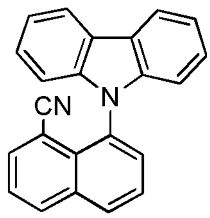

244—328

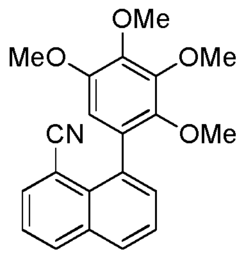

244—344

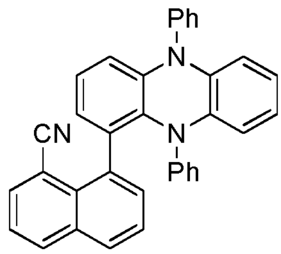

244—425

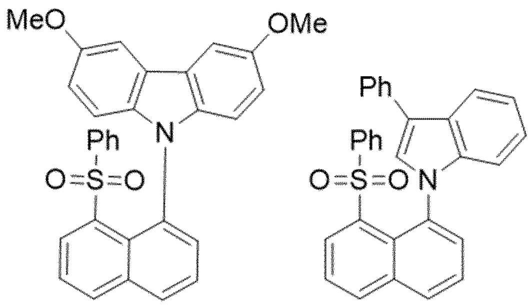

245—199 245—63

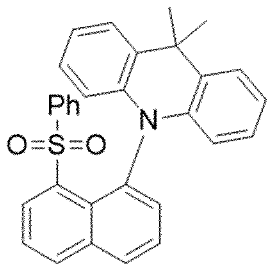

245—337

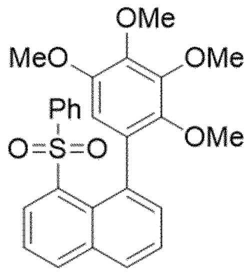

245—344

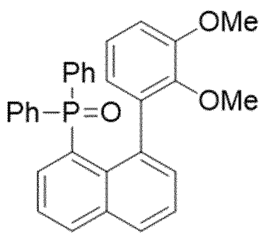

318—346

**Tabelle 3a:** Beispiele für weitere organische Moleküle (AF1-AF2) gemäß der Beschreibung.

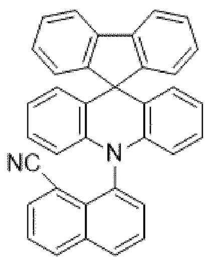

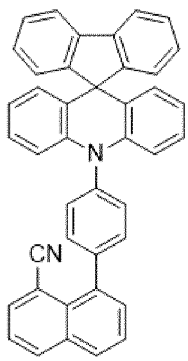

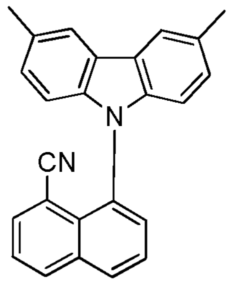
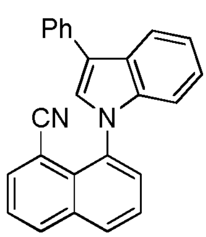
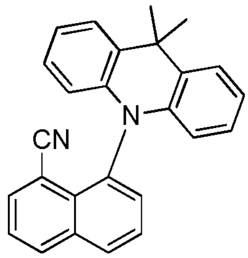
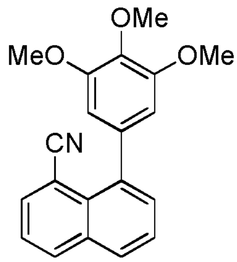

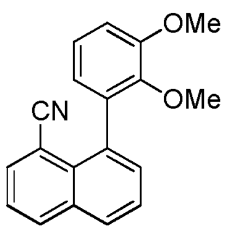
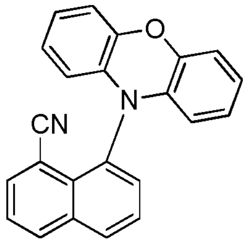
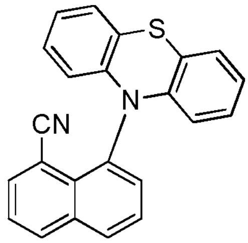

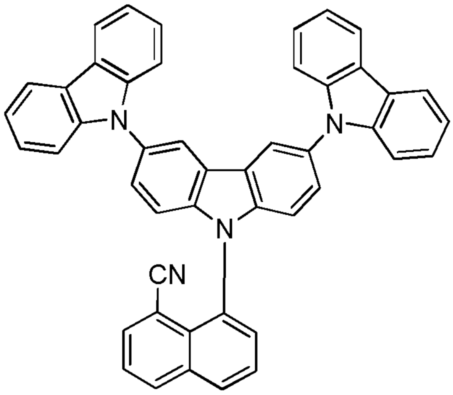
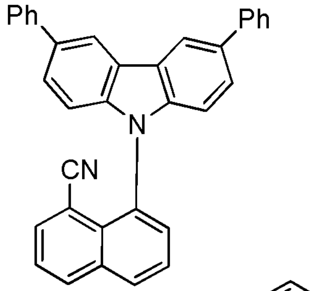
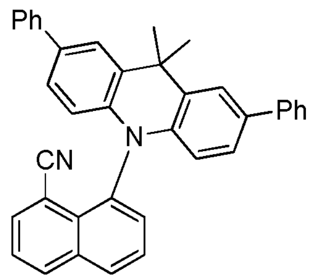

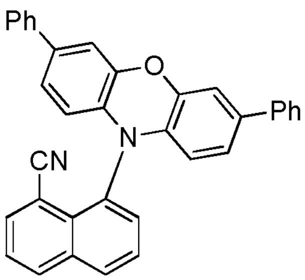
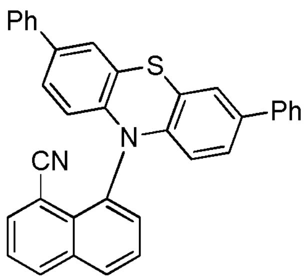
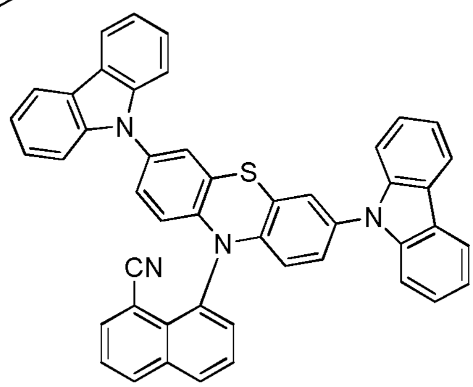

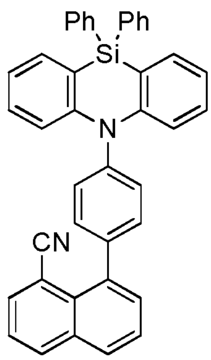
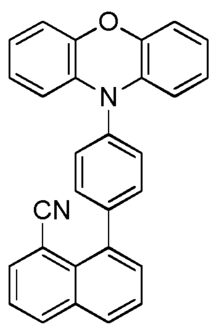
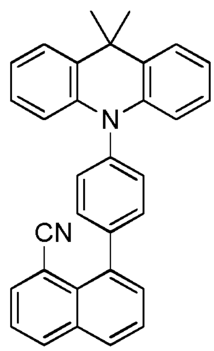
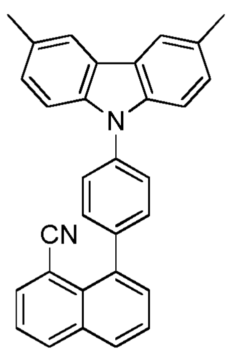

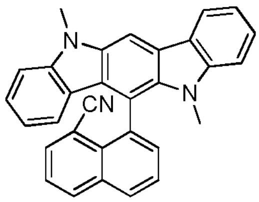
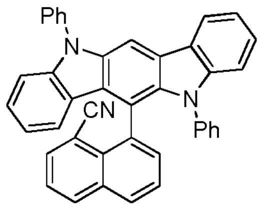
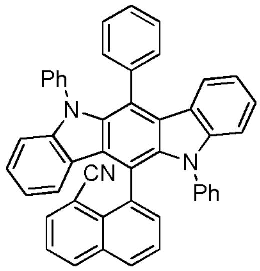
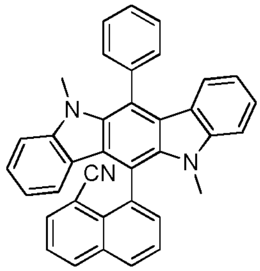

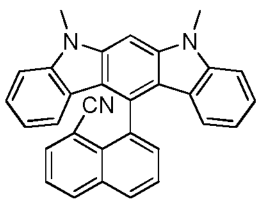
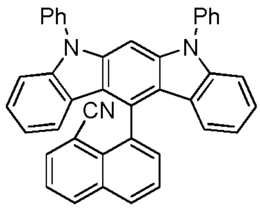
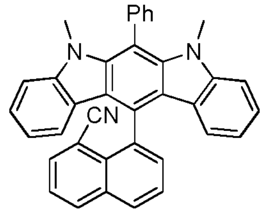
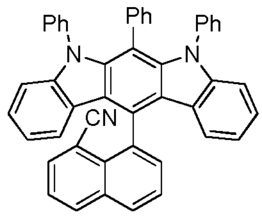

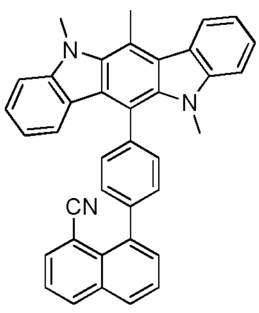
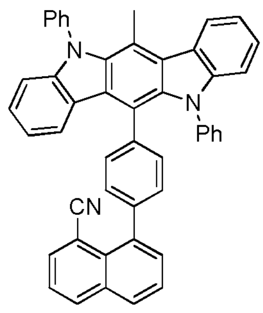
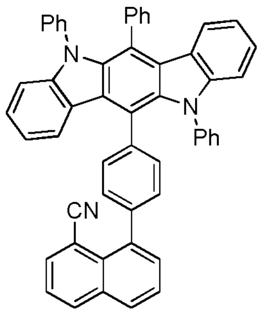

Die Erlaubtheit eines quantenmechanischen Überganges ist, wie allgemein bekannt, entweder durch theoretisch ableitbare spektroskopische Auswahlregeln (symmetrische Moleküle) oder durch Messung des Extinktionskoeffizienten (UV/VIS-Spektroskopie) oder quantenchemische Berechnung der Oszillatorstärke zugänglich, wobei sich Erlaubtheit durch eine große Oszillatorstärke auszeichnet. Je größer die Oszillatorstärke, desto schneller der damit verbundene Prozess. Bei einer langen Abklingdauer des (organischen) Emitters kommt es bei hohen Stromstärken schnell zu Sättigungseffekten, was die Bauteillebensdauer negativ beeinflusst und die Erreichung hoher Helligkeiten verhindert. Wird wie in der vorliegenden Erfindung durch eine geeignete Wahl des Anknüpfungsmotivs der AF1 eine gewisse Durchdringung von HOMO und LUMO erreicht, steigt das quantenmechanische Überlappungsintegral, und damit auch die Oszillatorstärke, so dass die Abklingzeit auf Werte unter 50 $\mu$s absinkt. Dies wird durch die erfindungsgemäße AF1 erreicht.

Durch Kombination der oben definierten Paare aus chemischen Einheiten AF1 und AF2 ergeben sich entsprechend die beispielhaften erfindungsgemäßen Moleküle der **Tabelle 3.** Weitere organische Moleküle können durch Kombination der genannten Moleküleinheiten analog erhalten werden.

Erfindungsgemäße organische Moleküle sind in Tabelle 4 dargestellt die sich durch Kombination der oben definierten Paare aus chemischen Einheiten AF1 und AF2 und der Festlegung der Verknüpfung ergeben. Weitere organische Moleküle können durch Kombination der genannten Moleküleinheiten erhalten werden. Die Benennung der Moleküle erfolgt nach dem Schema AF--AF, wobei hinsichtlich der Benennung der chemischen Einheit AF2 auf Tabelle 1 verweisen wird, da die in der Tabelle 1 verwendeten Nummern auch in Tabelle 3 verwendet werden. Hinsichtlich der Benennung der chemischen Einheit AF1 wird auf Tabelle 2 verwiesen, da die Nummerierung der AF auch hier verwendet wurde. Der Übersichtlichkeit halber werden die beiden Nummern durch den Buchstaben S getrennt.

Weitere organische Moleküle gemäß der Beschreibung sind in Tabelle 4a dargestellt die sich durch Kombination der oben definierten Paare aus chemischen Einheiten AF1 und AF2 und der Festlegung der Verknüpfung ergeben.

**Tabelle 4:** Erfindungsgemäße organische Moleküle nach dem Schema AF1-S-AF2. In Klammern sind die Werte für ΔHOMO, ΔLUMO und Gap angegeben.

| | | | |
|---|---|---|---|
| 6 - S - 244 (1.37 0.97 1.69) | 21 - S - 244 (1.24 1.00 1.81) | 55 - S - 244 (0.96 1.18 2.09) | 63 - S - 245 (1.02 1.202.18) |
| 77 - S - 244 (1.56 1.17 1.49) | 120 - S - 244 (0.96 2.13 2.09) | 199 - S - 244 (1.55 1.26 1.50) | 199 - S - 245 (1.47 1.04 1.73) |
| 200 - S - 244 (1.09 1.30 1.96) | 223 - S - 244 (1.26 1.63 1.79) | 328 - S - 244 (0.90 1.19 2.15) | 337 - S - 245 (1.37 1.48 1.83) |
| 344 - S - 244 (1.16 2.19 1.90) | 344 - S - 245 (1.07 1.96 2.12) | 346 - S - 318 (0.83 0.96 3.26) | |

**Tabelle 4a:** Organische Moleküle gemäß der Beschreibung nach dem Schema AF1-S-AF2. In Klammern sind die Werte für ΔHOMO, ΔLUMO und Gap angegeben.

| | | | |
|---|---|---|---|
| 244 - S - 125 (0.91 1.70 1.36) | 244 - S - 152 (1.88 0.91 2.14) | 244 - S - 343 (2.26 1.01 2.05) | 244 - S - 429 (1.82 1.71 1.35) |
| 244 - S - 472 (0.82 1.28 1.77) | 245 - S - 125 (0.99 1.92 1.27) | 245 - S - 151 (1.32 0.84 2.35) | 245 - S - 152 (1.96 1.14 2.06) |
| 245 - S - 231 (0.81 0.81 2.39) | 245 - S - 271 (0.99 0.88 2.32) | 245 - S - 343 (2.34 1.23 1.96) | 245 - S - 371 (1.50 0.83 2.37) |
| 245 - S - 429 (1.90 1.93 1.26) | 245 - S - 472 (0.90 1.51 1.69) | 276 - S - 43 (0.96 1.74 1.78) | 276 - S - 46 (1.56 1.26 2.26) |
| 276 - S - 57 (1.23 2.28 1.25) | 276 - S - 70 (1.02 1.95 1.57) | 276 - S - 85 (0.81 1.07 2.46) | 276 - S - 107 (1.07 1.23 2.30) |
| 276 - S - 109 (0.86 1.75 1.77) | 276 - S - 133 (1.07 1.52 2.01) | 276 - S - 150 (1.89 1.39 2.14) | 276 - S - 151 (1.80 1.65 1.88) |
| 276 - S - 152 (2.44 1.95 1.58) | 276 - S - 153 (1.82 1.49 2.03) | 276 - S - 177 (0.90 1.17 2.36) | 276 - S - 184 (1.64 0.98 2.54) |
| 276 - S - 192 (1.25 1.50 2.02) | 276 - S - 195 (1.07 0.83 2.70) | 276 - S - 207 (0.81 1.81 1.72) | 276 - S - 215 (1.05 2.07 1.45) |
| 276 - S - 231 (1.29 1.62 1.91) | 276 - S - 246 (0.81 1.37 2.15) | 276 - S - 247 (0.95 2.58 0.95) | 276 - S - 248 (0.88 1.92 1.61) |
| 276 - S - 255 (1.20 1.59 1.94) | 276 - S - 259 (1.06 2.41 1.12) | 276 - S - 270 (0.86 2.27 1.26) | 276 - S - 271 (1.47 1.68 1.84) |
| 276 - S - 291 (1.55 1.532.00) | 276 - S - 292 (0.88 1.19 2.34) | 276 - S - 294 (0.84 1.03 2.50) | 276 - S - 296 (0.87 1.27 2.26) |
| 276 - S - 306 (0.92 1.59 1.94) | 276 - S - 320 (1.14 2.01 1.52) | 276 - S - 324 (1.12 2.50 1.02) | 276 - S - 329 (0.86 1.80 1.73) |
| 276 - S - 342 (2.29 1.55 1.98) | 276 - S - 343 (2.82 2.04 1.49) | 276 - S - 364 (1.00 2.17 1.36) | 276 - S - 367 (0.82 1.49 2.03) |
| 276 - S - 368 (0.93 2.04 1.49) | 276 - S - 371 (1.98 1.64 1.89) | 276 - S - 395 (1.01 1.34 2.19) | 276 - S - 471 (0.80 0.91 2.62) |
| 276 - S - 472 (1.38 2.32 1.21) | 276 - S - 473 (0.85 1.52 2.01) | 318 - S - 46 (1.02 1.29 2.80) | 318 - S - 125 (0.93 2.75 1.34) |
| 318 - S - 150 (1.35 1.41 2.68) | 318 - S - 151 (1.26 1.67 2.42) | 318 - S - 152 (1.90 1.97 2.12) | 318 - S - 153 (1.28 1.51 2.58) |
| 318 - S - 184 (1.10 1.01 3.09) | 318 - S - 271 (0.93 1.71 2.38) | 318 - S - 291 (1.01 1.55 2.54) | 318 - S - 342 (1.75 1.57 2.52) |
| 318 - S - 343 (2.28 2.06 2.03) | 318 - S - 371 (1.44 1.66 2.43) | 318 - S - 429 (1.84 2.76 1.33) | 318 - S - 472 (0.84 2.34 1.75) |
| 1 - S - 244 (1.12 1.06 1.93) | 1 - S - 245 (1.04 0.84 2.16) | 2 - S - 244 (1.11 0.98 1.94) | 3 - S - 244 (1.37 1.44 1.68) |
| 3 - S - 245 (1.29 1.21 1.91) | 4 - S - 244 (1.00 0.90 2.06) | | 7 - S - 244 (1.36 0.98 1.69) |

(fortgesetzt)

| | | | |
|---|---|---|---|
| 8 - S - 244 (1.22 1.11 1.83) | 8 - S - 245 (1.14 0.88 2.06) | 10 - S - 244 (1.39 0.91 1.66) | 13 - S - 244 (1.43 1.36 1.62) |
| 13 - S - 245 (1.35 1.13 1.85) | 14 - S - 244 (0.84 1.00 2.21) | 15 - S - 245 (2.30 0.93 0.90) | 16 - S - 244 (1.36 0.97 1.69) |
| 17 - S - 244 (1.68 1.08 1.37) | 17 - S - 245 (1.60 0.85 1.60) | 18 - S - 244 (1.63 0.81 1.42) | |
| 22 - S - 244 (1.77 1.34 1.28) | 22 - S - 245 (1.69 1.11 1.51) | 23 - S - 244 (1.66 1.49 1.39) | 23 - S - 245 (1.58 1.27 1.62) |
| 24 - S - 244 (1.40 0.89 1.65) | 26 - S - 244 (1.76 1.80 1.29) | 26 - S - 245 (1.68 1.57 1.52) | 32 - S - 244 (0.90 0.91 2.16) |
| 33 - S - 244 (0.95 0.88 2.10) | 34 - S - 244 (1.07 0.89 1.98) | 35 - S - 244 (0.94 0.93 2.12) | 39 - S - 244 (1.37 1.67 1.68) |
| 39 - S - 245 (1.29 1.45 1.91) | 41 - S - 244 (1.68 1.52 1.37) | 41 - S - 245 (1.60 1.30 1.60) | 49 - S - 245 (2.08 1.45 1.12) |
| 53 - S - 244 (1.14 1.24 1.92) | 53 - S - 245 (1.05 1.01 2.14) | 54 - S - 244 (1.04 0.98 2.01) | |
| 55 - S - 245 (0.88 0.95 2.31) | 60 - S - 244 (0.96 0.85 2.09) | 63 - S - 244 (1.10 1.43 1.95) | |
| 64 - S - 244 (1.03 0.94 2.02) | 66 - S - 244 (2.04 1.50 1.01) | 66 - S - 245 (1.96 1.27 1.24) | 71 - S - 244 (1.11 0.96 1.94) |
| 72 - S - 244 (1.37 1.71 1.68) | 72 - S - 245 (1.29 1.48 1.90) | 73 - S - 244 (1.27 1.74 1.78) | 73 - S - 245 (1.19 1.51 2.01) |
| 75 - S - 244 (1.72 0.83 1.33) | 76 - S - 244 (2.05 1.28 1.00) | 76 - S - 245 (1.97 1.05 1.23) | |
| 77 - S - 245 (1.48 0.94 1.71) | 78 - S - 244 (1.74 1.22 1.31) | 78 - S - 245 (1.66 0.99 1.54) | 88 - S - 244 (1.04 0.85 2.01) |
| 91 - S - 244 (1.79 2.23 1.26) | 91 - S - 245 (1.71 2.00 1.49) | 91 - S - 276 (1.23 1.19 2.30) | 91 - S - 318 (1.77 1.17 2.32) |
| 94 - S - 244 (1.30 1.27 1.75) | 94 - S - 245 (1.22 1.05 1.98) | 95 - S - 244 (1.29 1.16 1.76) | 95 - S - 245 (1.21 0.93 1.98) |
| 97 - S - 244 (1.39 1.40 1.66) | 97 - S - 245 (1.31 1.17 1.89) | 103 - S - 244 (1.95 1.26 1.10) | 103 - S - 245 (1.87 1.03 1.33) |
| 104 - S - 244 (0.84 1.062.22) | 117 - S - 244 (1.13 1.32 1.93) | 117 - S - 245 (1.04 1.09 2.15) | |
| 120 - S - 245 (0.88 1.91 2.32) | 120 - S - 318 (0.94 1.08 3.15) | 128 - S - 244 (1.44 2.04 1.62) | 128 - S - 245 (1.35 1.81 1.84) |
| 128 - S - 276 (0.88 1.01 2.65) | 128 - S - 318 (1.42 0.98 2.67) | 129 - S - 244 (0.82 1.74 2.24) | 130 - S - 244 (1.51 1.44 1.54) |
| 130 - S - 245 (1.43 1.22 1.77) | 134 - S - 244 (0.98 3.08 2.07) | 134 - S - 245 (0.90 2.85 2.30) | 134 - S - 318 (0.96 2.02 3.13) |
| 137 - S - 244 (1.64 1.21 1.41) | 137 - S - 245 (1.56 0.98 1.64) | 140 - S - 244 (0.86 1.88 2.20) | 140 - S - 318 (0.84 0.82 3.25) |
| 149 - S - 244 (1.13 1.40 1.93) | 149 - S - 245 (1.04 1.17 2.15) | 156 - S - 244 (0.95 2.53 2.10) | 156 - S - 245 (0.87 2.31 2.33) |
| 156 - S - 318 (0.93 1.48 3.16) | | | |
| 200 - S - 245 (1.01 1.08 2.19) | 212 - S - 244 (1.39 0.86 1.66) | | 223 - S - 245 (1.18 1.41 2.02) |
| 224 - S - 244 (0.87 0.91 2.18) | 235 - S - 244 (1.15 2.85 1.90) | 235 - S - 245 (1.07 2.62 2.13) | 235 - S - 318 (1.14 1.79 2.95) |
| 242 - S - 244 (1.07 1.66 1.98) | 242 - S - 245 (0.99 1.43 2.21) | 256 - S - 244 (1.50 1.61 1.55) | 256 - S - 245 (1.42 1.38 1.78) |
| 278 - S - 244 (1.56 1.00 1.50) | 281 - S - 244 (1.88 1.23 1.17) | 281 - S - 245 (1.80 1.01 1.40) | 283 - S - 244 (1.76 1.01 1.29) |

(fortgesetzt)

| | | | |
|---|---|---|---|
| 314 - S - 244 (1.79 1.72 1.26) | 314 - S - 245 (1.71 1.50 1.49) | 315 - S - 245 (2.16 1.76 1.04) | 315 - S - 276 (1.68 0.95 1.84) |
| 315 - S - 318 (2.23 0.93 1.86) | 317 - S - 244 (1.37 1.44 1.68) | 317 - S - 245 (1.29 1.22 1.91) | 321 - S - 244 (1.61 1.23 1.45) |
| 321 - S - 245 (1.52 1.00 1.67) | 322 - S - 245 (2.11 1.31 1.09) | 323 - S - 244 (1.38 1.44 1.67) | 323 - S - 245 (1.30 1.21 1.90) |
| | 328 - S - 245 (0.82 0.97 2.38) | 337 - S - 244 (1.45 1.71 1.60) | |
| 339 - S - 244 (1.51 2.07 1.54) | 339 - S - 245 (1.43 1.85 1.77) | 339 - S - 276 (0.95 1.04 2.58) | 339 - S - 318 (1.49 1.022.60) |
| | | 344 - S - 318 (1.14 1.13 2.95) | 345 - S - 244 (1.03 2.03 2.02) |
| 345 - S - 245 (0.95 1.81 2.25) | 345 - S - 318 (1.01 0.98 3.08) | 346 - S - 244 (0.85 2.02 2.20) | |
| 347 - S - 244 (0.90 2.11 2.15) | 347 - S - 245 (0.82 1.88 2.38) | 347 - S - 318 (0.88 1.05 3.21) | 348 - S - 244 (1.25 1.87 1.81) |
| 348 - S - 245 (1.16 1.64 2.03) | 348 - S - 318 (1.23 0.81 2.86) | 351 - S - 244 (0.84 1.92 2.22) | 351 - S - 318 (0.82 0.86 3.27) |
| 354 - S - 244 (1.18 1.35 1.88) | 354 - S - 245 (1.09 1.12 2.10) | 355 - S - 245 (2.09 0.84 1.11) | 359 - S - 244 (0.96 1.08 2.09) |
| 359 - S - 245 (0.88 0.85 2.32) | 361 - S - 244 (1.20 1.47 1.85) | 361 - S - 245 (1.12 1.25 2.08) | 366 - S - 244 (0.82 1.53 2.23) |
| 369 - S - 244 (1.31 1.36 1.74) | 369 - S - 245 (1.23 1.13 1.97) | 375 - S - 244 (1.30 1.04 1.75) | 375 - S - 245 (1.22 0.82 1.98) |
| 377 - S - 244 (1.35 1.08 1.70) | 377 - S - 245 (1.27 0.86 1.92) | 383 - S - 244 (1.53 2.13 1.52) | 383 - S - 245 (1.45 1.90 1.75) |
| 383 - S - 276 (0.97 1.09 2.56) | 383 - S - 318 (1.51 1.07 2.58) | 384 - S - 244 (0.99 1.87 2.06) | 384 - S - 245 (0.91 1.65 2.29) |
| 384 - S - 318 (0.98 0.82 3.11) | 385 - S - 244 (1.70 1.91 1.36) | 385 - S - 245 (1.61 1.68 1.58) | 385 - S - 276 (1.14 0.87 2.39) |
| 385 - S - 318 (1.68 0.85 2.41) | 386 - S - 244 (1.68 1.59 1.37) | 386 - S - 245 (1.60 1.36 1.60) | 387 - S - 244 (1.59 2.14 1.46) |
| 387 - S - 245 (1.51 1.91 1.69) | 387 - S - 276 (1.03 1.10 2.49) | 387 - S - 318 (1.57 1.08 2.52) | 388 - S - 244 (1.12 1.83 1.93) |
| 388 - S - 245 (1.04 1.60 2.16) | 389 - S - 244 (1.75 1.93 1.30) | 389 - S - 245 (1.67 1.70 1.53) | 389 - S - 276 (1.19 0.89 2.34) |
| 389 - S - 318 (1.73 0.87 2.36) | 390 - S - 244 (1.75 1.58 1.31) | 390 - S - 245 (1.66 1.35 1.53) | 392 - S - 244 (1.02 1.26 2.03) |
| 392 - S - 245 (0.94 1.03 2.26) | 399 - S - 244 (1.65 1.49 1.40) | 399 - S - 245 (1.57 1.26 1.63) | 402 - S - 244 (1.36 1.19 1.69) |
| 402 - S - 245 (1.28 0.96 1.92) | 404 - S - 244 (1.49 2.15 1.56) | 404 - S - 245 (1.41 1.92 1.79) | 404 - S - 276 (0.93 1.11 2.60) |
| 404 - S - 318 (1.47 1.09 2.62) | 405 - S - 244 (1.14 1.47 1.91) | 405 - S - 245 (1.06 1.242.14) | 406 - S - 244 (1.43 2.05 1.63) |
| 406 - S - 245 (1.34 1.83 1.85) | 406 - S - 276 (0.87 1.02 2.66) | 406 - S - 318 (1.41 1.00 2.68) | 407 - S - 244 (1.56 2.09 1.49) |
| 407 - S - 245 (1.48 1.86 1.72) | 407 - S - 276 (1.00 1.06 2.53) | 407 - S - 318 (1.54 1.03 2.55) | 408 - S - 244 (1.24 1.93 1.81) |
| 408 - S - 245 (1.16 1.70 2.04) | 408 - S - 318 (1.22 0.87 2.87) | 409 - S - 244 (1.39 1.91 1.67) | 409 - S - 245 (1.30 1.69 1.89) |
| 409 - S - 276 (0.83 0.88 2.70) | 409 - S - 318 (1.37 0.86 2.72) | 410 - S - 244 (1.49 2.22 1.56) | 410 - S - 245 (1.41 1.99 1.79) |

(fortgesetzt)

| | | | |
|---|---|---|---|
| 410 - S - 276 (0.93 1.19 2.59) | 410 - S - 318 (1.47 1.16 2.62) | 411 - S - 244 (1.56 2.29 1.49) | 411 - S - 245 (1.48 2.06 1.71) |
| 411 - S - 276 (1.01 1.25 2.52) | 411 - S - 318 (1.55 1.23 2.54) | 412 - S - 244 (1.18 2.05 1.87) | 412 - S - 245 (1.10 1.82 2. 10) |
| 412 - S - 318 (1.16 1.002.93) | 413 - S - 244 (1.97 2.47 1.08) | 413 - S - 245 (1.89 2.24 1.31) | 413 - S - 276 (1.41 1.44 2.11) |
| 413 - S - 318 (1.96 1.42 2.13) | 414 - S - 244 (1.99 2.49 1.07) | 414 - S - 245 (1.90 2.26 1.29) | 414 - S - 276 (1.43 1.45 2.10) |
| 414 - S - 318 (1.97 1.43 2.12) | 416 - S - 244 (1.27 1.64 1.78) | 416 - S - 245 (1.19 1.41 2.01) | 417 - S - 244 (1.57 2.23 1.49) |
| 417 - S - 245 (1.48 2.00 1.71) | 417 - S - 276 (1.01 1.19 2.52) | 417 - S - 318 (1.55 1.17 2.54) | 418 - S - 244 (1.53 1.58 1.52) |
| 418 - S - 245 (1.45 1.35 1.75) | 422 - S - 244 (1.13 0.84 1.92) | 423 - S - 244 (1.15 1.77 1.90) | 423 - S - 245 (1.07 1.54 2.13) |
| 424 - S - 244 (1.23 1.88 1.82) | 424 - S - 245 (1.15 1.65 2.05) | 424 - S - 318 (1.21 0.822.88) | 425 - S - 245 (2.15 1.14 1.05) |
| 426 - S - 244 (1.20 1.60 1.85) | 426 - S - 245 (1.12 1.37 2.08) | 427 - S - 244 (1.51 1.88 1.54) | 427 - S - 245 (1.43 1.65 1.76) |
| 427 - S - 276 (0.96 0.84 2.57) | 427 - S - 318 (1.50 0.82 2.59) | 428 - S - 244 (1.97 1.37 1.08) | 428 - S - 245 (1.89 1.14 1.30) |
| 436 - S - 244 (1.29 1.23 1.76) | 436 - S - 245 (1.21 1.01 1.99) | 448 - S - 244 (0.98 0.92 2.07) | 477 - S - 244 (1.81 1.25 1.24) |
| 477 - S - 245 (1.73 1.02 1.47) | 478 - S - 244 (1.87 1.29 1.18) | 478 - S - 245 (1.79 1.07 1.41) | 479 - S - 244 (2.00 1.15 1.05) |
| 479 - S - 245 (1.92 0.93 1.28) | 480 - S - 244 (0.84 1.15 2.22) | 481 - S - 244 (1.29 1.86 1.77) | 481 - S - 245 (1.20 1.64 1.99) |
| 481 - S - 318 (1.27 0.81 2.82) | 485 - S - 244 (1.68 1.52 1.37) | 485 - S - 245 (1.60 1.30 1.59) | |

In einer Ausführungsform werden an die chemisch substituierbaren Positionen der so erhaltenen organischen Moleküle weitere Reste R angefügt, um die Löslichkeit der Emitter zu steigern und/oder die Polymerisierbarkeit zu ermöglichen ohne dabei die elektronischen Eigenschaften des Moleküls signifikant zu verändern, sodass auch bei Verwendung von R ein Emitter vorliegt, wobei

jedes R und bei jedem Auftreten gleich oder verschieden ist H, Deuterium, F, Cl, Br, I, $N(R^2)_2$, CN, $CF_3$, $NO_2$, OH, COOH, $COOR^2$, $CO(NR^2)_2$, $Si(R^2)_3$, $B(OR^2)_2$, $C(=O)R^2$, $P(=O)(R^2)_2$, $S(=O)R^2$, $S(=O)_2R^2$, $OSO_2R^2$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^2$ substituiert sein kann, wobei eine oder mehrere nicht benachbarte $CH_2$-Gruppen durch $R^2C=CR^2$, C≡C, $Si(R^2)_2$, $Ge(R^2)_2$, $Sn(R^2)_2$, C=O, C=S, C=Se, $C=NR^2$, $P(=O)(R^2)$, SO, $SO_2$, $NR^2$, O, S oder $CONR^2$ ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^2$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^2$ substituiert sein kann, oder eine Kombination dieser Systeme; dabei können zwei oder mehrere dieser Substituenten $R^1$ auch miteinander ein mono- oder polycyclisches, aliphatisches, aromatisches und/oder benzoannelliertes Ringsystem bilden. In einer Ausführungsform ist das Ringsystem, das gebildet werden kann, auf ein mono- oder polycyclisches, aliphatisches, aromatisches und/oder benzoannelliertes Ringsystem beschränkt.

$R^2$ bei jedem Auftreten gleich oder verschieden ist H, Deuterium, F, Cl, Br, I, $N(R^3)_2$, CN, $CF_3$, $NO_2$, OH, COOH, $COOR^3$, $CO(NR^3)_2$, $Si(R^3)_3$, $B(OR^3)_2$, $C(=O)R^3$, $P(=O)(R^3)_2$, $S(=O)R^3$, $S(=O)_2R^3$, $OSO_2R^3$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^3$ substituiert sein kann, wobei eine oder mehrere nicht benachbarte $CH_2$-Gruppen

durch $R^3C=CR^3$, C≡C, $Si(R^3)_2$, $Ge(R^3)_2$, $Sn(R^3)_2$, C=O, C=S, C=Se, $C=NR^3$, $P(=O)(R^3)$, SO, $SO_2$, $NR^3$, O, S oder $CONR^3$ ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^3$ substituiert sein kann, oder eine Aryloxy- oder Heteroaryloxygruppe mit 5 bis 60 aromatischen Ringatomen, die durch einen oder mehrere Reste $R^3$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^3$ substituiert sein kann, oder eine Kombination dieser Systeme; dabei können zwei oder mehrere dieser Substituenten $R^2$ auch miteinander ein mono- oder polycyclisches, aliphatisches, aromatisches und/oder benzoannelliertes Ringsystem bilden;

$R^3$ bei jedem Auftreten gleich oder verschieden ist H, Deuterium, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten $R^3$ auch miteinander ein mono- oder polycyclisches, aliphatisches Ringsystem bilden.

Polymerisierbare Reste sind solche Reste, die polymerisierbare funktionelle Einheiten tragen, die mit sich selbst homopolymerisiert oder mit anderen Monomeren copolymiersiert werden können. Somit können die erfindungsgemäßen Moleküle als Polymer mit folgenden Wiederholungseinheiten der Formeln 7 und 8 erhalten werden, die als Polymere in der lichtemittierenden Schicht des optoelektronischen Bauelements Verwendung finden können.

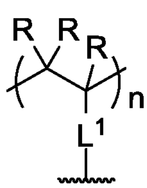
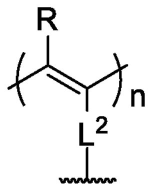

**Formel 7** **Formel 8**

R ist dabei wie oben angegeben definiert. In Formel 7 und 8 stehen L1 und L2 für gleiche oder verschiedene Linkergruppen, die 0 bis 20, insbesondere 1 bis 15, oder 2 bis 10 Kohlenstoffatome aufweist, und wobei die gewellte Linie die Position kennzeichnet, über die die Linkergruppe an das organische Molekül der Formel 1 angebunden ist. In einer Ausführungsform weist die Linkergruppe L1 und/oder L2 eine Form -X-L3- auf, wobei X für O oder S steht und L3 für eine Linkergruppe ausgewählt aus der Gruppe aus einer substituierten und unsubstituierten Alkylengruppe (linear, verzweigt oder cyclisch) und einer substituierten und unsubstituierten Arylengruppe, insbesondere eine substituierte oder unsubstituierte Alkylengruppe mit 1 bis 10 Kohlenstoffatomen oder eine substituierte oder unsubstituierte Phenylengruppe, wobei auch Kombinationen möglich sind. In einer weiteren Ausführungsform weist die Linkergruppe L1 und/oder L2 eine Form -C(=O)O- auf. R ist bei jedem Auftreten unabhängig voneinander ausgewählt aus der Gruppe bestehend aus H, Deuterium, Phenyl, Naphthyl, F, $CF_3$ oder ein aliphatischer, aromatischer und/oder heteroaromatischer Kohlenwasserstoffrest mit 1 bis 20 C-Atomen, in dem auch ein oder mehrere H-Atome durch F oder $CF_3$ ersetzt sein können; dabei können zwei oder mehrere Substituenten R auch miteinander ein mono- oder polycyclisches, aliphatisches Ringsystem bilden, außerdem kann R sein: eine lineare Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen.

Vorteilhafte Ausführungsformen der Wiederholungseinheiten sind Strukturen der Formeln 9 bis 14:

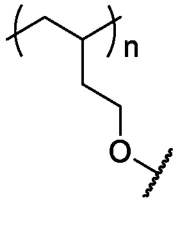
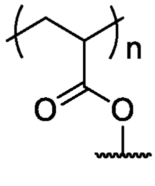
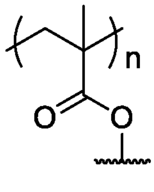
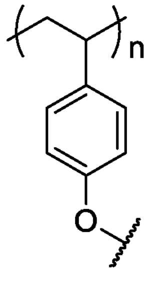
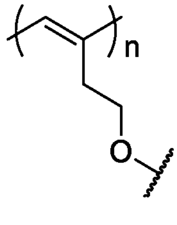
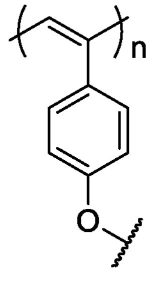

**Formel 9** **Formel 10** **Formel 11** **Formel 12** **Formel 13** **Formel 14**

Zur Herstellung der Polymere, die die Wiederholungseinheiten gemäß Formel 9 bis 14 aufweisen, werden die polymerisierbaren funktionellen Einheiten über eine Linkergruppe der Formeln 15 bis 20, die eine Hydroxyleinheit aufweisen, an ein organisches Molekül der Formel 1 angebunden und die daraus resultierenden Verbindungen mit sich selbst homopolymerisiert oder mit anderen geeigneten Monomeren copolymerisiert.

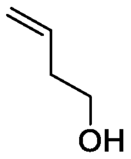 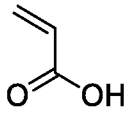 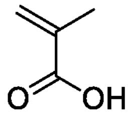 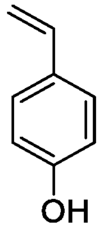 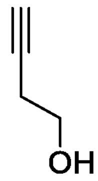 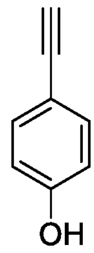

**Formel 15** **Formel 16** **Formel 17** **Formel 18** **Formel 19** **Formel 20**

Polymere, die eine Einheit gemäß Formel 7 oder Formel 8 aufweisen, können dabei entweder ausschließlich Wiederholungseinheiten mit einer Struktur der allgemeinen Formel 7 oder 8, oder Wiederholungseinheiten mit einer anderen Struktur aufweisen. Beispiele von Wiederholungseinheiten mit anderen Strukturen weisen Einheiten auf, die sich aus entsprechenden Monomeren ergeben, die typischerweise in Copolymerisationen eingesetzt oder verwendet werden. Beispiele für derartige Wiederholungseinheiten, die sich aus Monomeren ergeben, sind Wiederholungseinheiten, die ungesättigte Einheiten wie Ethylen oder Styrol aufweisen.

Eine Ausführungsform der Erfindung betrifft organische Moleküle, welche

- einen $\Delta E(S_1-T_1)$-Wert zwischen dem untersten angeregten Singulett ($S_1$)- und dem darunter liegenden Triplett ($T_1$)-Zustand von kleiner als 0,2 eV, insbesondere kleiner als 0,1 eV aufweisen und/oder
- eine Emissionslebensdauer von höchstens 50 $\mu$s aufweisen.

Die Erfindung betrifft in einem Aspekt die Verwendung eines erfindungsgemäßen organischen Moleküls als lumineszierender Emitter und/oder als Hostmaterial und/oder als Elektronentransportmaterial und/oder als Lochinjektionsmaterial und/oder als Lochblockiermaterial in einem optoelektronischen Bauelement, das insbesondere durch ein Vakuumverdampfungsverfahren oder aus Lösung hergestellt wird, wobei das optoelektronische Bauelement insbesondere ausgewählt ist aus der Gruppe bestehend aus:

- organischen lichtemittierenden Dioden (OLEDs),
- lichtemittierenden elektrochemischen Zellen,
- OLED-Sensoren, insbesondere in nicht hermetisch nach außen abgeschirmten Gas- und Dampf-Sensoren,
- organischen Dioden
- organischen Solarzellen,
- organischen Transistoren,
- organischen Feldeffekttransistoren,
- organischen Lasern und
- Down-Konversions-Elementen.

Der Anteil des erfindungsgemäßen organischen Moleküls am lumineszierenden Emitter und/oder Hostmaterial und/oder Elektronentransportmaterial und/oder Lochinjektionsmaterial und/oder Lochblockiermaterial beträgt in einer Ausführungsform 1 % bis 99 % (Gew%), insbesondere beträgt der Anteil am Emitter in optischen Licht emittierenden Bauelementen, insbesondere in OLEDs, zwischen 5 % und 80 %.

Die Erfindung betrifft in einem weiteren Aspekt optoelektronische Bauelemente, aufweisend ein erfindungsgemäßes organisches Molekül, wobei das optoelektronische Bauelement insbesondere ausgeformt ist als ein Bauelement ausgewählt aus der Gruppe bestehend aus organischer lichtemittierender Diode (OLED), lichtemittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

Eine Ausführungsform betrifft das erfindungsgemäße optoelektronische Bauelement aufweisend ein Substrat, eine Anode und eine Kathode, wobei die Anode und die Kathode auf das Substrat aufgebracht sind, und mindestens eine lichtemittierende Schicht, welche zwischen Anode und Kathode angeordnet ist und die ein erfindungsgemäßes

organisches Molekül enthält.

In einer weiteren Ausführungsform des Bauelements wird das organische Molekül als Emissionsmaterial in einer Emissionsschicht eingesetzt, wobei sie in Kombination mit mindestens einem Hostmaterial oder insbesondere als Reinschicht eingesetzt werden kann. In einer Ausführungsform beträgt dabei der Anteil des organischen Moleküls als Emissionsmaterial in einer Emissionsschicht in optischen lichtemittierender Bauelementen, insbesondere in OLEDs, zwischen 5 % und 80 % (Gew%).

In einer weiteren Ausführungsform des erfindungsgemäßen Bauelements ist die ein erfindungsgemäßes organisches Molekül aufweisende lichtemittierende Schicht auf ein Substrat aufgebracht.

In einer Ausführungsform betrifft die Erfindung ein optoelektronisches Bauelement, bei dem die lichtemittierende Schicht ausschließlich ein erfindungsgemäßes organisches Molekül in 100 % Konzentration aufweist, wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement neben dem erfindungsgemäßen organischen Molekül mindestens ein Hostmaterial auf, wobei insbesondere der angeregte Singulettzustand ($S_1$) und/oder der angeregte Triplettzustand ($T_1$) des mindestens einen Hostmaterials höher ist als der angeregte Singulettzustand ($S_1$) und/oder der angeregte Triplettzustand ($T_1$) des organischen Moleküls, und wobei die Anode und die Kathode auf das Substrat aufgebracht ist, und die lichtemittierende Schicht zwischen Anode und Kathode aufgebracht ist.

In einer weiteren Ausführungsform weist das optoelektronische Bauelement ein Substrat, eine Anode, eine Kathode und mindestens je eine löcherinjizierende und eine elektroneninjizierende Schicht und mindestens eine lichtemittierende Schicht auf, wobei die mindestens eine lichtemittierende Schicht ein erfindungsgemäßes organisches Molekül und ein Hostmaterial aufweist, dessen Triplett ($T_1$)- und Singulett ($S_1$)-Energieniveaus energetisch höher liegen als die Triplett ($T_1$)- und Singulett ($S_1$)-Energieniveaus des organischen Moleküls, und wobei die Anode und die Kathode auf das Substrat aufgebracht ist, und die löcher- und elektroneninjizierende Schicht zwischen Anode und Kathode aufgebracht ist und die lichtemittierende Schicht zwischen löcher- und elektroneninjizierende Schicht aufgebracht ist.

In einer weiteren Ausführungsform weist das optoelektronische Bauelement ein Substrat, eine Anode, eine Kathode und mindestens je eine löcherinjizierende und eine elektroneninjizierende Schicht, und mindestens je eine löchertransportierende und eine elektronentransportierende Schicht, und mindestens eine lichtemittierende Schicht auf, wobei die mindestens eine lichtemittierende Schicht ein erfindungsgemäßes organisches Molekül sowie ein Hostmaterial aufweist, dessen Triplett ($T_1$)- und Singulett ($S_1$)-Energieniveaus energetisch höher liegen als die Triplett ($T_1$)- und Singulett ($S_1$)-Energieniveaus des organischen Moleküls, und wobei die Anode und die Kathode auf das Substrat aufgebracht ist, und die löcher- und elektroneninjizierende Schicht zwischen Anode und Kathode aufgebracht ist, und die löcher- und elektronentransportierende Schicht zwischen löcher- und elektroneninjizierende Schicht aufgebracht ist, und die lichtemittierende Schicht zwischen löcher- und elektronentransportierende Schicht aufgebracht ist.

In einer weiteren Ausführungsform weist das optoelektronische Bauelement mindestens ein Hostmaterial aus einem Material gemäß Formel 1 auf.

In einer weiteren Ausführungsform des optoelektronischen Bauelements beinhaltet die lichtemittierende Schicht fluoreszente oder phosphoreszente Materialien, welche eine Struktur der Formel 1 aufweisen.

In einer weiteren Ausführungsform des optoelektronischen Bauelements bilden ein organisches Molekül gemäß Formel 1 und ein funktionelles Material, beispielsweise in Form eines weiteren Emitter-Materials, eines Host-Materials, oder eines weiteren organisches Moleküls, welches zur Bildung eines Exciplex mit dem Molekül gemäß Formel 1 befähigt ist, einen Exciplex. Funktionelle Materialien sind beispielsweise Hostmaterialien wie MCP, Elektronentransportmaterialien wie TPBI und Lochtransportmaterialien wie NPD oder MTDATA. Exciplexe sind Addukte aus elektronisch angeregten Molekülen und solchen im elektronischen Grundzustand, die zur Lichtemission fähig sind.

In einer weiteren Ausführungsform des optoelektronischen Bauelements ist die Emission durch thermisch aktivierte verzögerte Fluoreszenz (TADF) charakterisiert.

In einer weiteren Ausführungsform des optoelektronischen Bauelements werden organische Moleküle gemäß Formel 1 als Ladungstransportschicht verwendet.

Die Erfindung betrifft in einem Aspekt ein lichtemittierendes Material, aufweisend ein erfindungsgemäßes organisches Molekül und ein Hostmaterial, wobei die Triplett ($T_1$)- und Singulett ($S_1$)-Energieniveaus des Hostmaterials energetisch höher liegen als die Triplett ($T_1$)- und Singulett ($S_1$)-Energieniveaus des organischen Moleküls, und wobei das organische Molekül Fluoreszenz oder thermisch aktivierte verzögerte Fluoreszenz (TADF) emittiert, und einen $\Delta E(S_1-T_1)$-Wert zwischen dem untersten angeregten Singulett ($S_1$)- und dem darunter liegenden Triplett ($T_1$)-Zustand von kleiner als 0,2 eV, insbesondere kleiner als 0,1 eV aufweist.

Ein Aspekt der Erfindung betrifft ein Verfahren zur Herstellung eines optoelektronischen Bauelements aufweisend ein erfindungsgemäßes organisches Molekül. In einer Ausführungsform weist das Verfahren den Schritt der Verarbeitung des organischen Moleküls mittels eines Vakuumverdampfungsverfahrens oder aus einer Lösung auf.

In einer Ausführungsform weist das Verfahren den Schritt des Aufbringens des organischen Moleküls auf einen Träger auf, wobei das Aufbringen insbesondere nass-chemisch, mittels kolloidaler Suspension oder mittels Sublimation

erfolgt.

In einer weiteren Ausführungsform des Verfahrens wird mindestens eine Schicht

- mit einem Sublimationsverfahren beschichtet
- mit einem OVPD (Organic Vapor Phase Deposition) Verfahren beschichtet
- mit Hilfe einer Trägergassublimation beschichtet oder
- aus Lösung oder mit einem beliebigen Druckverfahren hergestellt.

Ein Aspekt der Erfindung betrifft ein Verfahren zur Veränderung der Emissions- und/oder Absorptionseigenschaften eines elektronischen Bauelements, wobei ein erfindungsgemäßes organisches Molekül in ein Matrixmaterial zur Leitung von Elektronen oder Löchern in einem optoelektronischen Bauelement eingebracht wird.

Die Erfindung betrifft zudem in einem weiteren Aspekt die Verwendung eines erfindungsgemäßen Moleküls zur Umwandlung von UV-Strahlung oder von blauem Licht in sichtbares Licht, insbesondere in grünes, gelbes oder rotes Licht (Down-Konversion), insbesondere in einem optoelektronischen Bauelement der hier beschriebenen Art.

In einem weiteren Aspekt betrifft die Erfindung eine Anwendung, in der mindestens ein Material mit einer Struktur gemäß Formel 1, durch äußere energetische Anregung zum Leuchten angeregt wird. Die äußere Anregung kann elektronisch oder optisch oder radioaktiv sein.

In einer weiteren Ausführungsform des optoelektronischen Bauelements bilden ein organisches Molekül gemäß Formel 1 und ein funktionelles Material, beispielsweise in Form eines weiteren Emitter-Materials, eines Host-Materials, oder eines weiteren organisches Moleküls, welches zur Bildung eines Exciplex mit dem Molekül gemäß Formel 1 befähigt ist, einen Exciplex. Funktionelle Materialien sind beispielsweise Hostmaterialien wie MCP, Elektronentransportmaterialien wie TPBI und Lochtransportmaterialien wie NPD oder MTDATA. Exciplexe sind Addukte aus elektronisch angeregten Molekülen und solchen im elektronischen Grundzustand, die zur Lichtemission fähig sind.

## Beispiele

Ein Maß für die Abklingdauer ist der $\Delta E(S_1\text{-}T_1)$-Abstand. Je kleiner dieser Wert, desto vorteilhafter sind die Eigenschaften der erfindungsgemäßen Moleküle, wie bspw. die Abklingdauer. In einer Ausführungsform weist der $\Delta E(S_1\text{-}T_1)$-Abstand Werte von kleiner 0.3 eV auf. Dieser wird durch die Überlappung von HOMO und LUMO beeinflusst. Die Größe des quantenmechanischen Überlappungsintegrals, welche nach oben genannter DFT-Methode berechenbar ist, kann durch Anordnung der Einheiten AF1 und AF2 gezielt gesteuert werden. Kommt es zur völligen Trennung von HOMO und LUMO hat dieses einen Wert von 0. Die Wahrscheinlichkeit einer effizienten Emission des organischen Moleküls sinkt drastisch. Bei einem Wert von 1 liegt nicht mehr verzögerte Fluoreszenz (TADF) sondern spontane Emission vor. Die gewünschte Überlappung wird durch die geeignete Wahl der Anordnung der Einheiten AF1 und AF2 erreicht.

### Berechnungen nach der Dichtefuntionaltheorie

### Variante 1 (BP86)

Für die DFT-Rechnungen (Dichtefunktionaltheorie) wurde das BP86-Funktional (Becke, A. D. Phys. Rev. A1988, 38, 3098-3100; Perdew, J. P. Phys. Rev. B1986, 33, 8822-8827) und def2-SV(P)-Basissätze (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) verwendet. Zur numerischen Integration kam das m4-Grid zum Einsatz und die resolution-of-identity-Näherung (RI) (Häser, M.; Ahlrichs, R. J. Comput. Chem. 1989, 10, 104-111; Weigend, F.; Häser, M. Theor. Chem. Acc. 1997, 97, 331-340; Sierka, M.; Hogekamp, A.; Ahlrichs, R. J. Chem. Phys. 2003, 118, 9136-9148) wurde in allen Rechnungen verwendet. Die DFT-Rechnungen wurden mit dem Turbomole-Programmpaket (Version 6.5) (TURBOMOLE V6.4 2012, University of Karlsruhe/Forschungszentrum Karlsruhe GmbH, 1989-2007, TURBOMOLE GmbH, since 2007; http://www.turbomole.com) durchgeführt.

### Variante 2 (TD-B3LYP)

Für die Optimierung der Molekülstrukturen wurde das BP86-Funktional (Becke, A. D. Phys. Rev. A1988, 38, 3098-3100; Perdew, J. P. Phys. Rev. B1986, 33, 8822-8827) verwendet, wobei die resolution-of-identity-Näherung (RI) (Sierka, M.; Hogekamp, A.; Ahlrichs, R. J. Chem. Phys. 2003, 118, 9136-9148; Becke, A.D., J.Chem.Phys. 98 (1993) 5648-5652; Lee, C; Yang, W; Parr, R.G. Phys. Rev. B 37 (1988) 785-789) zum Einsatz kam. Anregungsenergien wurden bei der mit BP86 optimierten Struktur mit der Time-Dependent DFT-Methode (TD-DFT) unter Verwendung des B3LYP-Funktionals (Becke, A.D. , J.Chem.Phys. 98 (1993) 5648-5652; Lee, C; Yang, W; Parr, R.G. Phys. Rev. B 37 (1988)

785-789; Vosko, S. H.; Wilk, L.; Nusair, M. Can. J. Phys. 58 (1980) 1200-1211; Stephens, P. J.; Devlin, F. J.; Chabalowski, C. F. ; Frisch, M. J. J.Phys.Chem. 98 (1994) 11623-11627) berechnet. In allen Rechnungen wurden def2-SV(P)-Basissätze (Weigend, F.; Ahlrichs, R. Phys. Chem. Chem. Phys. 2005, 7, 3297-3305; Rappoport, D.; Furche, F. J. Chem. Phys.2010, 133, 134105/1-134105/11) und ein m4 -Grid zur numerischen Integration verwendet. Alle DFT-Rechnungen wurden mit dem Turbomole-Programmpaket (Version 6.5) (TURBOMOLE V6.4 2012, University of Karlsruhe und Forschungszentrum Karlsruhe GmbH, 1989-2007, TURBOMOLE GmbH, since 2007; http://www.turbomole.com) durchgeführt.

| Struktur | ∆E [eV] |
|---|---|
| 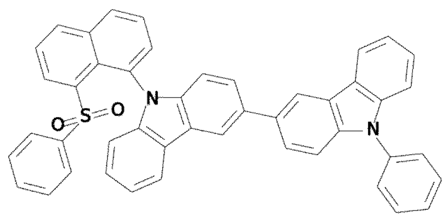 245-1' | 0.238eV |
| 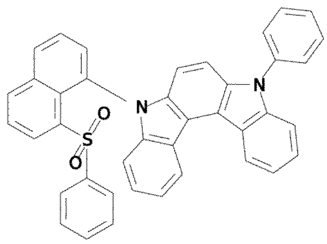 245-7 | 0.222eV |
| 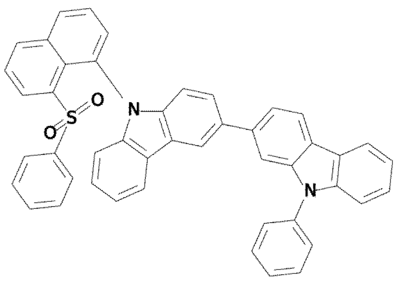 245-1 | 0.242eV |
| 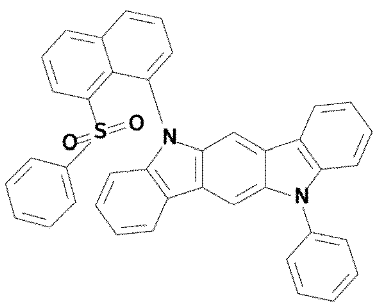 245-24 | 0.261eV |

(fortgesetzt)

| Struktur | ∆E [eV] |
|---|---|
| 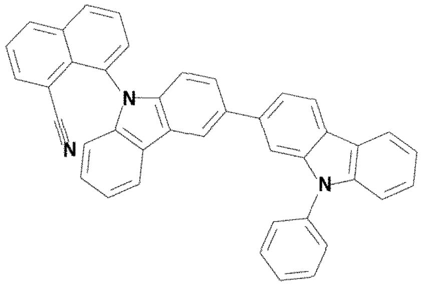 244-1 | 0.026eV |
| 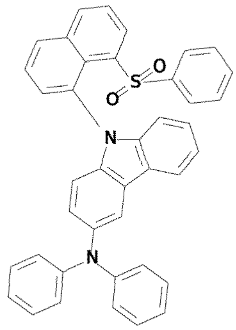 | 0.203eV |
| 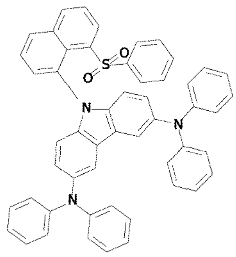 245-74 | 0.021eV |
| 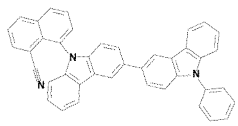 244-1' | 0.055eV |
| 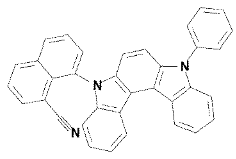 244-7 | 0.171eV |
| 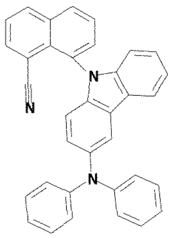 244- | 0.081eV |

(fortgesetzt)

| Struktur | ΔE [eV] |
|---|---|
| 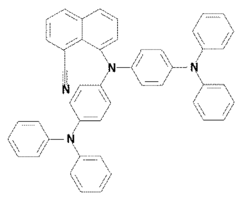 | 0.042eV |
| 244-22 | |
| 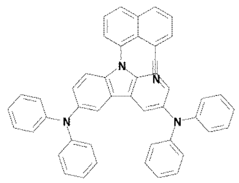 244-74 | 0.010eV |
| 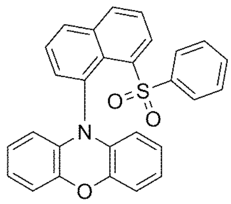 245-41- | 0.178eV |
| 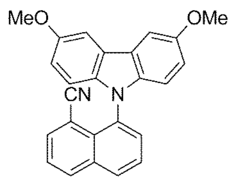 244-199 | 0.003eV |
| 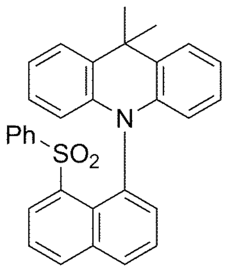 245-337 | 0.201 eV |

Syntheseweg für Verbindung 244-199:

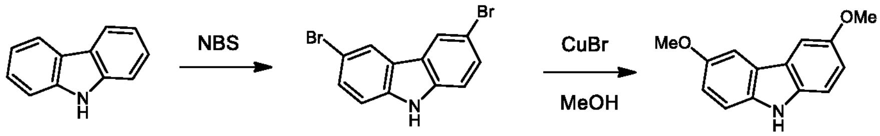


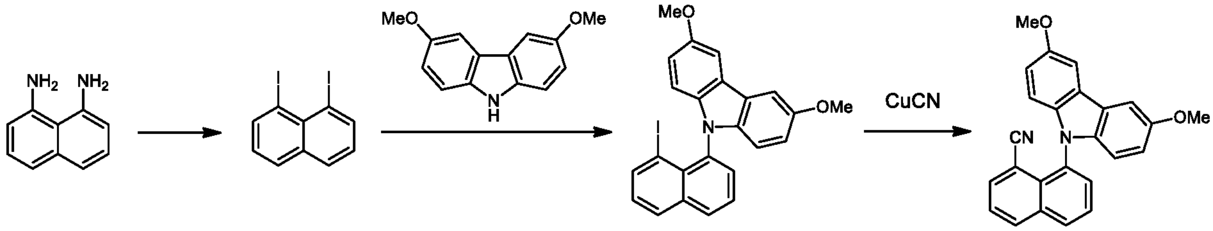


Carbazol wird mit N-Bromsuccinimid zweifach bromiert und dann kupferkatalysiert in Methanol zum Dimethoxycarbazol umgesetzt.

1,8-Diaminonaphthain wird durch Diazotierung in 1,8-Diiodnaphthalin überführt und kupferkatalysiert mit dem Dimethoxycarbazol zur erfindungsgemäßen Verbindung 244-199 umgesetzt.

## Figuren

Es zeigen

Figur 1: Schematische Darstellung des Aufbaus einer organischen lichtemittierenden Diode (OLED).

Figur 2: Schematische Darstellung des Energieniveaudiagrammes (relative Energie in eV) eines erfindungsgemäßen Emittermoleküls (Lichtemission resultiert aus dem Übergang LUMO AF1 hin zu HOMO AF2).

## Patentansprüche

1. Organisches Molekül, wobei das Molekül ausgewählt ist aus den nachfolgenden Verbindungen:

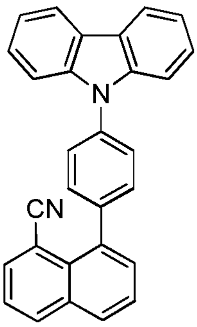
244—55

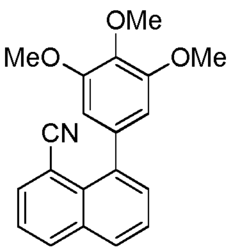
244—120

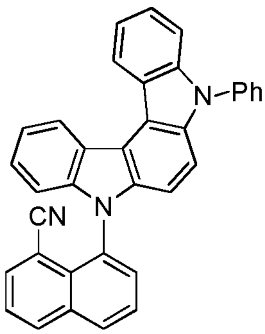
244—6

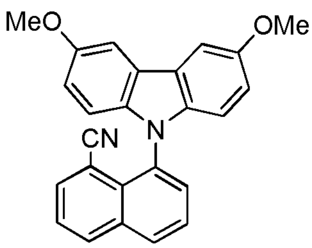
244—199

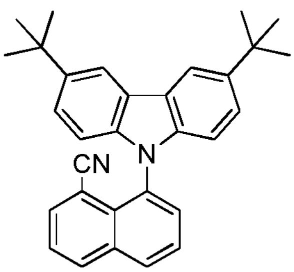
244—200

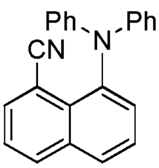
244—223

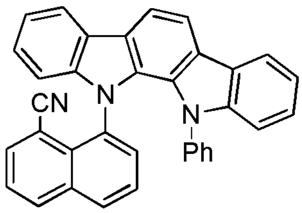
244—21

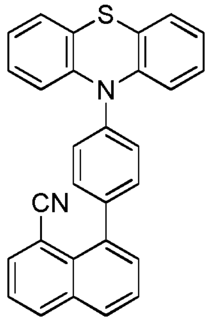

244—77

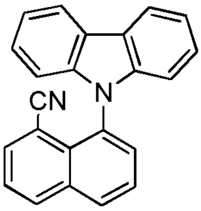

244—328

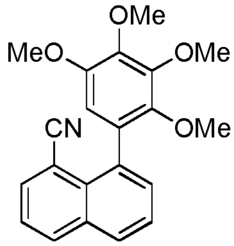

244—344

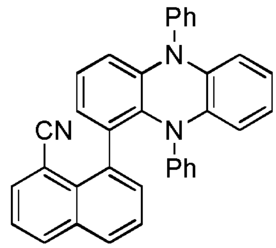

244—425

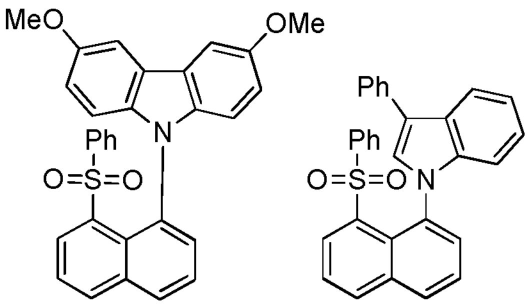

245—199

245—63

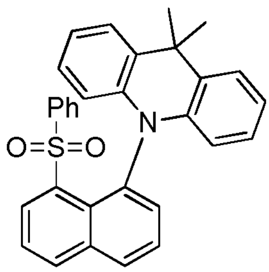

245—337

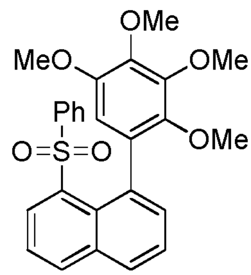

245—344

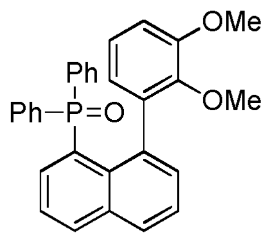

318—346

**2.** Organisches Molekül nach Anspruch 1, wobei das organische Molekül an mindestens einer chemisch substituierbaren Position mindestens einen weiteren Rest R, insbesondere zur Steigerung der Löslichkeit und/oder der Polymerisierbarkeit, aufweist, wobei
R ist bei jedem Auftreten unabhängig voneinander ausgewählt aus der Gruppe bestehend aus H, Deuterium, Phenyl, Naphthyl, F, Cl, Br, I, $N(R^2)_2$, -CN, -NC, -SCN, - $CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, eine lineare Alkyl-, Alkoxy- oder Thioalkoxygruppe mit 1 bis 40 C-Atomen oder eine lineare Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils mit einem oder mehreren Resten $R^9$ substituiert sein kann, wobei eine oder mehrere benachbarte $CH_2$-Gruppen durch $-R^9C=CR^9-$, -C≡C-, oder eine benachbarte $CH_2$-Gruppe durch $-Si(R^4)_2-$, $-Ge(R^4)_2-$, $-Sn(R^4)_2-$, -C(=O)-, -C(=S)-, -C(=Se)-, -C=N-, - C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, oder-S- ersetzt sein können und wobei ein oder mehrere H-Atome durch Deuterium, F, Cl, Br, I, CN, $CF_3$ oder $NO_2$ ersetzt sein können, oder ein aromatisches oder heteroaromatisches Ringsystem mit 5 bis 60 aromatischen Ringatomen, das jeweils durch einen oder mehrere Reste $R^2$ substituiert sein kann, oder eine Aryloxy- oder Heteroaryloxygruppe mit 5 bis 60 aromatischen Ringatomen, die durch einen oder mehrere Reste $R^9$ substituiert sein kann, oder eine Diarylaminogruppe, Diheteroarylaminogruppe oder Arylheteroarylaminogruppe mit 10 bis 40 aromatischen Ringatomen, welche durch einen oder mehrere Reste $R^9$ substituiert sein kann, oder eine Kombination dieser Systeme; dabei können zwei oder mehrere dieser Substituenten R auch miteinander ein mono- oder polycyclisches, aliphatisches, aromatisches und/oder benzoannelliertes Ringsystem bilden; wobei $R^2$ bis $R^9$ definiert

sind wie in Anspruch 1;
und Reste aufweisend polymerisierbare funktionelle Einheiten, die mit sich selbst homopolymerisiert oder mit anderen Monomeren copolymiersiert werden können, zu einem organischen Molekül in Form eines Polymers mit Wiederholungseinheiten nach den Formeln 7 und/oder 8 führen

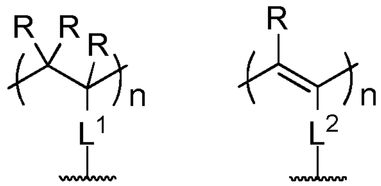

**Formel 7** **Formel 8**

mit

gewellte Linie = Position, über die die Linkergruppe $L^1$ oder $L^2$ an das organische Molekül gebunden ist;
$L^1$ und $L^2$ = gleiche oder verschiedene Linkergruppen, aufweisend zwischen 0 bis 20 Kohlenstoffatome; oder aufweisend eine Form -C(=O)O;
und wobei insbesondere $L^1$ und $L^2$ = -X-$L^3$ mit X = O oder S;
$L^3$ = eine weitere Linkergruppe ausgewählt aus der Gruppe aus einersubstituierten und unsubstituierten Alkylengruppe (linear, verzweigt oder cyclisch) und einer substituierten und unsubstituierten Arylengruppe, wobei auch Kombinationen möglich sind.

3. Verwendung eines organischen Moleküls nach Anspruch 1 oder 2 als lumineszierender Emitter und/oder als Hostmaterial und/oder als Elektronentransportmaterial und/oder als Lochinjektionsmaterial und/oder als Lochblockiermaterial in einem optoelektronischen Bauelement.

4. Verwendung nach Anspruch 3, wobei das optoelektronische Bauelement ausgewählt ist aus der Gruppe bestehend aus:

- organischen lichtemittierenden Dioden (OLEDs),
- Licht-emittierenden elektrochemischen Zellen,
- OLED-Sensoren, insbesondere in nicht hermetisch nach außen abgeschirmten Gas- und Dampf-Sensoren,
- organischen Dioden
- organischen Solarzellen,
- organischer Transistor
- organischen Feldeffekttransistoren,
- organischen Lasern und
- Down-Konversions-Elementen.

5. Verwendung nach Anspruch 3 oder 4, wobei der Anteil des organischen Moleküls an der Emissionsschicht in einer optoelektronischen Vorrichtung, insbesondere in OLEDs, 1 % bis 99 % beträgt.

6. Verwendung nach Anspruch 3 bis 5, wobei die Konzentration des organischen Moleküls als Emitter in optischen lichtemittierenden Bauelementen, insbesondere in OLEDs, zwischen 5 % und 80 % beträgt.

7. Optoelektronisches Bauelement, aufweisend ein organisches Molekül nach Anspruch 1 oder 2, insbesondere ausgeformt als ein Bauelement ausgewählt aus der Gruppe bestehend aus organischer lichtemittierender Diode (OLED), lichtemittierender elektrochemischer Zelle, OLED-Sensor, insbesondere in nicht hermetisch nach außen abgeschirmten Gas- und Dampf-Sensoren, organischer Diode, organischer Solarzelle, organischem Transistor, organischem Feldeffekttransistor, organischem Laser und Down-Konversion-Element.

8. Optoelektronisches Bauelement nach Anspruch 7, aufweisend

- ein Substrat,
- eine Anode und

- eine Kathode, wobei die Anode und die Kathode auf das Substrat aufgebracht sind, und
- mindestens eine lichtemittierende Schicht, die zwischen Anode und Kathode angeordnet ist und die ein organisches Molekül nach Anspruch 1 oder 2 enthält.

**9.** Optoelektronisches Bauelement nach Anspruch 8, in dem die lichtemittierende Schicht mindestens ein Hostmaterial aufweist, wobei der angeregte Singulettzustand ($S_1$) und/oder der angeregte Triplettzustand ($T_1$) des mindestens einen Hostmaterials höher ist als der angeregte Singulettzustand ($S_1$) und/oder der angeregte Triplettzustand ($T_1$) des organischen Moleküls nach Anspruch 1 oder 2.

**10.** Optoelektronisches Bauelement nach Anspruch 7 oder 8, aufweisend mindestens ein Hostmaterial bestehend aus einem Material gemäß Anspruch 1 oder 2.

**11.** Optoelektronisches Bauelement nach Anspruch 7 bis 10, wobei die lichtemittierende Schicht fluoreszente oder phosphoreszente Materialien beinhaltet und wobei es sich bei den Materialien der lichtemittierenden Schicht um organische Moleküle nach Anspruch 1 oder 2 handelt.

**12.** Optoelektronisches Bauelement nach Anspruch 7 bis 11, in dem ein organisches Molekül gemäß Anspruch 1 oder 2 zusammen mit einem funktionellen Material einen Exciplex bilden.

**13.** Optoelektronisches Bauelement nach Anspruch 7 bis 12, wobei die Emission durch thermisch aktivierte verzögerte Fluoreszenz (TADF) charakterisiert ist.

**14.** Optoelektronisches Bauelement nach Anspruch 7 bis 13, in dem ein organisches Molekül nach Anspruch 1 oder 2 als Ladungstransportschicht verwendet wird.

**15.** Verfahren zur Herstellung eines optoelektronischen Bauelements, wobei ein organisches Molekül nach Anspruch 1 oder 2 verwendet wird.

**16.** Verfahren nach Anspruch 15, wobei die Verarbeitung des organischen Moleküls mittels eines Vakuumverdampfungsverfahrens oder aus einer Lösung erfolgt.

## Claims

**1.** Organic molecule, wherein the molecule is selected from the following compounds:

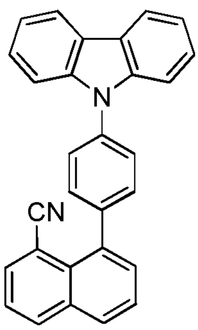

244—55

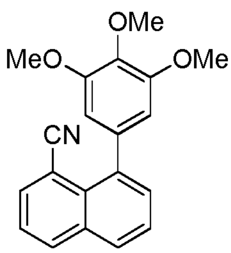

244—120

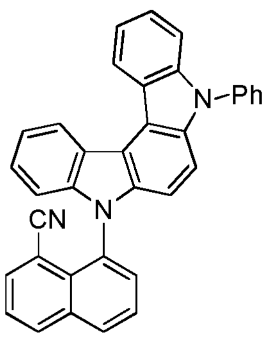

244—6

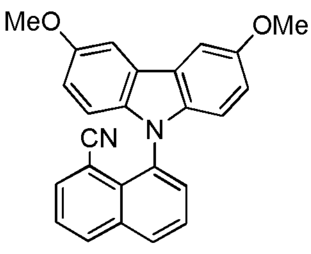

244—199

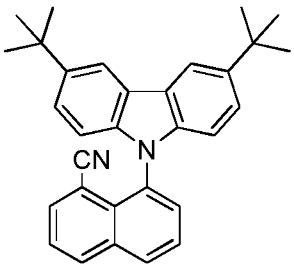
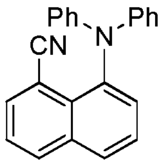
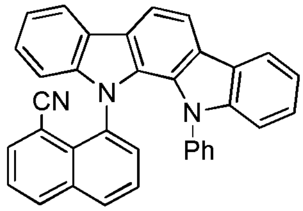

244—200 244—223 244—21

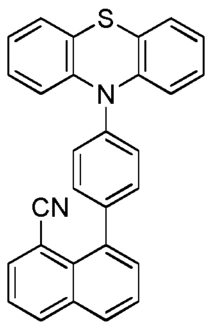
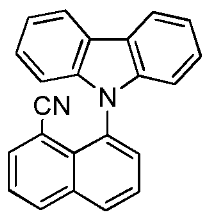
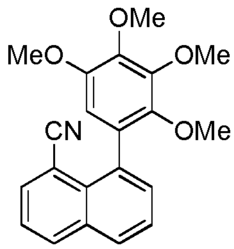
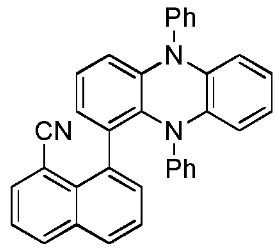

244—77 244—328 244—344 244—425

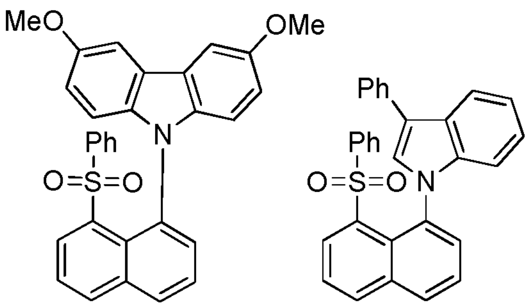
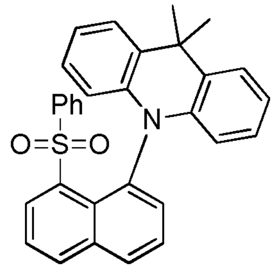
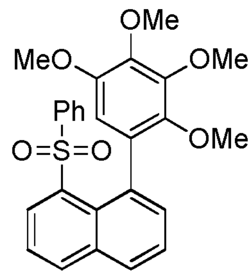

245—199 245—63 245—337 245—344

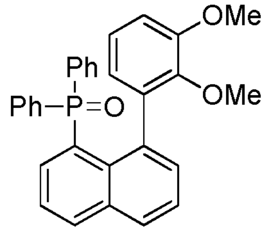

318—346

**2.** Organic molecule according to claim 1, wherein the organic molecule comprises at at least at one chemically substitutable position at least one further moiety R, in particular for increasing the solubility and/or the polymerzability, wherein

R is at each instance independently of each other selected from the group consisting of H, deuterium, phenyl, naphthyl, F, Cl, Br, I, $N(R^2)_2$, -CN, -NC, -SCN, $-CF_3$, $-NO_2$, -OH, C(=O)OH, C(=O)$OR^3$, C(=O)$N(R^3)_2$, C(=O)$SR^3$, C(=S)$SR^3$, $Si(R^4)_3$, $B(OR^5)_2$, $B(N(R^6)_2)_2$, C(=O)$R^3$, P(=O)$(R^7)_2$, As(=O)$(R^7)_2$, P(=S)$(R^7)_2$, As(=S)$(R^7)_2$, S(=O)$R^3$, S=$NR^3$, S(=O)$NR^3$, $S(=O)_2NR^3$, $S(=O)_2R^3$, O-$S(=O)_2R^3$, $SF_5$, a linear alkyl, alkoxy or thioalkoxy group having 1 to 40 carbon atoms or a linear alkenyl or alkynyl group having 2 to 40 carbon atoms or a branched or cyclic alkyl,

alkenyl, alkynyl, alkoxy or thioalkoxy group having 3 to 40 carbon atoms, each of which may be substituted by one or more $R^9$ moieties, where one or more adjacent $CH_2$ groups may be replaced by - $R^9C=CR^9$-, -C≡C-, or an adjacent $CH_2$ group may be replaced by -$Si(R^4)_2$-, -$Ge(R^4)_2$-, - $Sn(R^4)_2$-, -C(=O)-, -C(=S)-, -C(=Se)-, -C=N-, -C(=O)O-, -C(=O)N($R^3$)-, -P(=O)($R^7$)-, - As(=O)($R^7$)-, -P(=S)($R^7$)-, -As(=S)($R^7$)-, -S(=O)-, -$S(=O)_2$-, -$NR^2$-, -O-, or -S- and where one or more hydrogen atoms may be replaced by deuterium, F, Cl, Br, I, CN, $CF_3$ or $NO_2$, or an aromatic or heteroaromatic ring system having 5 to 60 aromatic ring atoms and may be substituted in each case by one or more $R^2$ moieties, or an aryloxy or heteroaryloxy group having 5 to 60 aromatic ring atoms and may be substituted by one or more $R^9$ moieties, or a diarylamino group, diheteroarylamino group or arylheteroarylamino group having 10 to 40 aromatic ring atoms and may be substituted by one or more $R^9$ moieties, or a combination of these systems; at the same time, two or more of these substituents R may also form together a mono- or polycyclic, aliphatic, aromatic and/or benzofused ring system; wherein $R^2$ to $R^9$ are defined as in claim 1;
and moieties comprising polymerizable functional units that can be homopolymerized with themselves or copolymerized with other monomers, leading to an organic molecule in the form of a polymer with repeating units according to formula 7 and/or 8

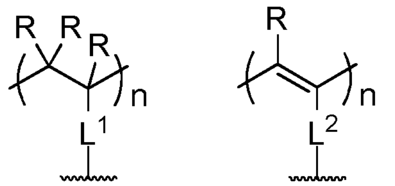

**Formula 7** **Formula 8**

with

wavy line = position via which the linker group $L^1$ or $L^2$ is bound to the organic molecule;
$L^1$ and $L^2$ = identical or different linker groups having between 0 and 20 carbon atoms; or comprising a form -C(=O)O;
and where, in particular, $L^1$ and $L^2$ = -X-$L^3$ with X = O or S;
$L^3$ = a further linker group selected from the group of a substituted and unsubstituted alkylene group (linear, branched or cyclic) and a substituted and unsubstituted arylene group, wherein combinations are also possible.

**3.** Use of an organic molecule according to claim 1 or 2 as luminescent emitter and/or as host material and/or as electron transport material and/or as hole injection material and/or as hole blocking material in an optoelectronic component.

**4.** Use according to claim 3, wherein the optoelectronic component is selected from the group consisting of:

- organic light-emitting diodes (OLEDs),
- light-emitting electrochemical cells,
- OLED sensors, especially in gas and vapor sensors that are not hermetically shielded from the outside,
- organic diodes,
- organic solar cells,
- organic transistors,
- organic field-effect transistors,
- organic lasers and
- down-conversion elements.

**5.** Use according to claim 3 or 4, wherein the proportion of the organic molecule in the emitter layer in an optoelectronic device, in particular in OLEDs, is 1% to 99%.

**6.** Use according to claims 3 to 5, wherein the concentration of the organic molecule as emitter in optical light-emitting components, in particular in OLEDs, is between 5% and 80%.

**7.** Optoelectronic component comprising an organic molecule according to claim 1 or 2, in particular in the form of a component selected from the group consisting of organic light-emitting diode (OLED), light-emitting electrochemical

cell, OLED sensor, especially in gas and vapor sensors that are not hermetically shielded from the outside, organic diode, organic solar cell, organic transistor, organic field-effect transistor, organic laser and down-conversion element.

**8.** Optoelectronic component according to claim 7, comprising

- a substrate,
- an anode and
- a cathode, wherein the anode and the cathode have been applied to the substrate, and
- at least one light-emitting layer which is disposed between the anode and the cathode and which comprises an organic molecule according to claim 1 or 2.

**9.** Optoelectronic component according to claim 8, in which the light-emitting layer comprises at least one host material, where the excited singlet state ($S_1$) and/or the excited triplet state ($T_1$) of the at least one host material is higher than the excited singlet state ($S_1$) and/or the excited triplet state ($T_1$) of the organic molecule according to claim 1 or 2.

**10.** Optoelectronic component according to claim 7 or 8, comprising at least one host material consisting of a material according to claim 1 or 2.

**11.** Optoelectronic component according to claims 7 to 10, wherein the light-emitting layer comprises fluorescent or phosphorescent materials and wherein the materials in the light-emitting layer are organic molecules according to claim 1 or 2.

**12.** Optoelectronic component according to claims 7 to 11, in which an organic molecule according to claim 1 or 2 forms an exciplex together with a functional material.

**13.** Optoelectronic component according to claims 7 to 12, wherein the emission is **characterized by** thermally activated delayed fluorescence (TADF).

**14.** Optoelectronic component according to claims 7 to 13, in which an organic molecule according to claim 1 or 2 is used as charge transport layer.

**15.** Method for producing an optoelectronic component, wherein an organic molecule according to claim 1 or 2 is used.

**16.** Method according to claim 15, wherein the organic molecule is processed by means of a vacuum evaporation process or from a solution.

## Revendications

**1.** Molécule organique, où la molécule est choisie parmi les composés suivants :

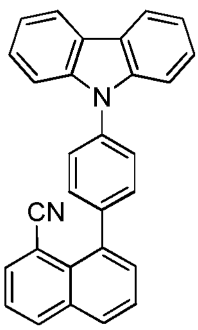
244—55

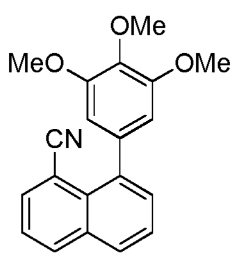
244—120

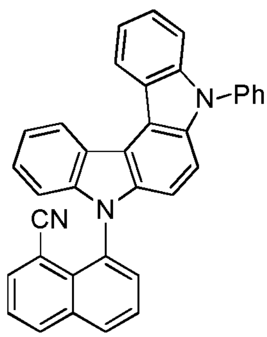
244—6

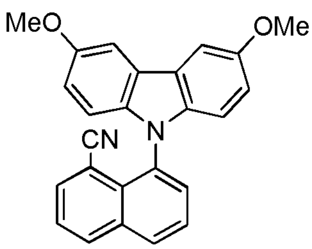
244—199

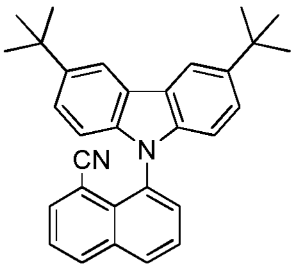 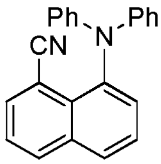 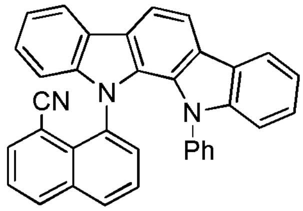

244—200 244—223 244—21

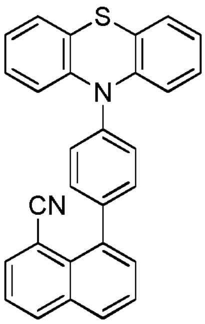 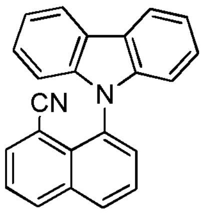 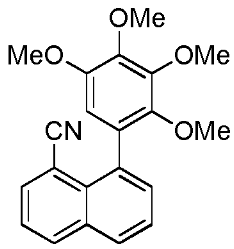 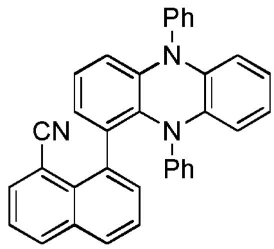

244—77 244—328 244—344 244—425

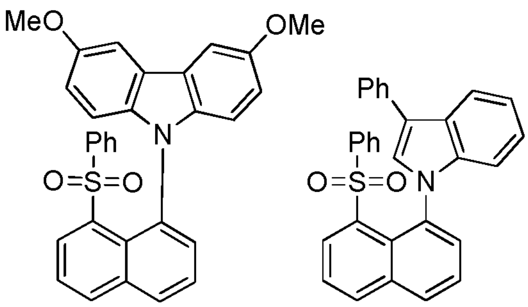 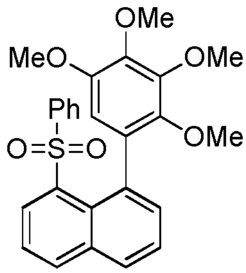 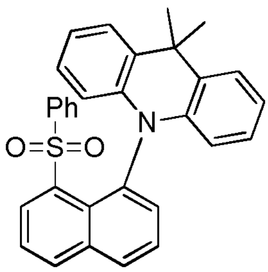

245—199 245—63 245—337 245—344

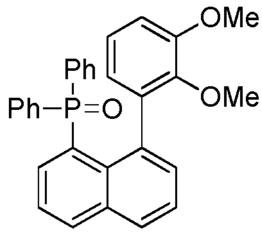

318—346

**2.** Molécule organique selon la revendication 1, où la molécule organique présente en au moins une position qui peut être substituée par voie chimique au moins un autre radical R, en particulier pour l'augmentation de la solubilité et/ou de l'aptitude à la polymérisation, où

R est choisi indépendamment à chaque occurrence dans le groupe constitué par H, le deutérium, les groupes phényle, naphtyle, F, Cl, Br, I, $N(R^2)_2$, -CN, -NC, -SCN, - $CF_3$, $-NO_2$, -OH, C(=O)OH, $C(=O)OR^3$, $C(=O)N(R^3)_2$, $C(=O)SR^3$, $C(=S)SR^3$, $Si(R^4)_3$, $B(OR^5)_2$, $B(N(R^6)_2)_2$, $C(=O)R^3$, $P(=O)(R^7)_2$, $As(=O)(R^7)_2$, $P(=S)(R^7)_2$, $As(=S)(R^7)_2$, $S(=O)R^3$, $S=NR^3$, $S(=O)NR^3$, $S(=O)_2NR^3$, $S(=O)_2R^3$, $O-S(=O)_2R^3$, $SF_5$, un groupe alkyle, alcoxy ou thioalcoxy linéaire ayant de 1 à 40 atomes de carbone ou un groupe alcényle ou alcynyle linéaire ayant de 2 à 40 atomes de

carbone ou un groupe alkyle, alcényle, alcynyle, alcoxy ou thioalcoxy ramifié ou cyclique ayant de 3 à 40 atomes de carbone, qui peut dans chaque cas être substitué par un ou plusieurs radicaux $R^9$, un ou plusieurs groupes $CH_2$ contigus pouvant être remplacés par $-R^9C=CR^9-$, -C°C-, ou un groupe $CH_2$ voisin pouvant être remplacé par $-Si(R^4)_2-$, $-Ge(R^4)_2-$, $-Sn(R^4)_2$, -C(=O)-, -C(=S)-, -C(=Se)-, -C=N-, -C(=O)O-, $-C(=O)N(R^3)-$, $-P(=O)(R^7)-$, $-As(=O)(R^7)-$, $-P(=S)(R^7)-$, $-As(=S)(R^7)-$, -S(=O)-, $-S(=O)_2-$, $-NR^2-$, -O-, ou -S- et un ou plusieurs atomes d'hydrogène pouvant être remplacés par le deutérium, F, Cl, Br, I, CN, $CF_3$ ou $NO_2$, ou un système cyclique aromatique ou hétéroaromatique ayant de 5 à 60 atomes formant le cycle aromatique, qui peut dans chaque cas être substitué par un ou plusieurs radicaux $R^2$, ou un groupe aryloxy ou hétéroaryloxy ayant de 5 à 60 atomes formant le cycle aromatique, qui peut être substitué par un ou plusieurs radicaux $R^9$, ou un groupe diarylamino, un groupe dihétéroarylamino ou un groupe arylhétéroarylamino ayant de 10 à 40 atomes formant le cycle aromatique, qui peut être substitué par un ou plusieurs radicaux $R^9$, ou une combinaison de ces systèmes ; deux ou plus de deux de ces substituants R peuvent en outre également former ensemble un système cyclique mono- ou polycyclique, aliphatique, aromatique et/ou soudé à un noyau benzénique ; $R^2$ à $R^9$ étant tels que définis dans la revendication 1 ;

et des radicaux présentant des unités fonctionnelles aptes à la polymérisation, qui peuvent être homopolymérisés avec eux-mêmes ou copolymérisés avec d'autres monomères, conduisent à une molécule organique sous forme d'un polymère à motifs répétitifs selon la formule 7 et/ou la formule 8

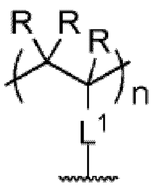

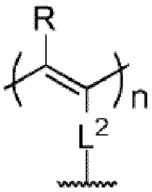

**Formule 7 Formule 8**

où

trait ondulé = position par laquelle le groupe de liaison $L^1$ ou $L^2$ est attaché à la molécule organique ;
$L^1$ et $L^2$ = des groupes de liaison identiques ou différents, comportant entre 0 et 20 atomes de carbone ; ou présentant une forme -C(C=O)O ;
et où en particulier $L^1$ et $L^2$ = $-X-L^3$ où X = O ou S ;
$L^3$ = un autre groupe de liaison choisi dans le groupe constitué par un groupe alkylène substitué et un groupe alkylène non substitué (linéaires, ramifiés ou cycliques) et un groupe arylène substitué et un groupe arylène non substitué, des associations étant également possibles.

**3.** Utilisation d'une molécule organique selon la revendication 1 ou 2 en tant qu'émetteur luminescent et/ou en tant que matériau hôte et/ou en tant que matériau transporteur d'électrons et/ou en tant que matériau d'injection de trous et/ou en tant que matériau de blocage de trous dans un composant optoélectronique.

**4.** Utilisation selon la revendication 3, dans laquelle le composant optoélectronique est choisi dans le groupe constitué par :

- des diodes électroluminescentes organiques (OLED),
- des cellules électrochimiques photoémettrices,
- des capteurs OLED, en particulier dans des capteurs de gaz et de vapeur non isolés hermétiquement de l'extérieur,
- des diodes organiques,
- des cellules solaires organiques,
- des transistors organiques,
- des transistors à effet de champ organiques,
- des lasers organiques et
- des éléments d'abaissement de fréquence.

**5.** Utilisation selon la revendication 3 ou 4, dans laquelle la proportion de la molécule organique dans la couche d'émission dans un dispositif optoélectronique, en particulier dans des OLED, vaut de 1 % à 99 %.

**6.** Utilisation selon l'une quelconque des revendications 3 à 5, dans laquelle la concentration de la molécule organique en tant qu'émetteur dans des composants luminescents optiques, en particulier dans des OLED, est comprise entre 5 % et 80 %.

**7.** Composant optoélectronique, comportant une molécule organique selon la revendication 1 ou 2, en particulier configuré sous forme d'un composant choisi dans le groupe constitué par des diodes électroluminescentes organiques (OLED), une cellule électrochimique photoémettrice, un capteur OLED, en particulier dans des capteurs de gaz et de vapeur non isolés hermétiquement de l'extérieur, des diodes organiques, une cellule solaire organique, un transistor organique, un transistor à effet de champ organique, un laser organique et un élément d'abaissement de fréquence.

**8.** Composant optoélectronique selon la revendication 7, comportant

- un substrat,
- une anode et
- une cathode, l'anode et la cathode étant appliquées sur le substrat, et
- au moins une couche photoémettrice qui est disposée entre l'anode et la cathode et qui comprend une molécule organique selon la revendication 1 ou 2.

**9.** Composant optoélectronique selon la revendication 8, dans lequel la couche photoémettrice comporte au moins un matériau hôte, où en particulier l'état singulet excité ($S_1$) et/ou l'état triplet excité ($T_1$) dudit au moins un matériau hôte est plus élevé que l'état singulet excité ($S_1$) et/ou que l'état triplet excité ($T_1$) de la molécule organique selon la revendication 1 ou 2.

**10.** Composant optoélectronique selon la revendication 7 ou 8, comportant au moins un matériau hôte consistant en un matériau selon la revendication 1 ou 2.

**11.** Composant optoélectronique selon l'une quelconque des revendications 7 à 10, dans lequel la couche photoémettrice comporte des matériaux fluorescents ou phosphorescents et dans lequel pour ce qui est des matériaux de la couche photoémettrice il s'agit de molécules organiques selon la revendication 1 ou 2.

**12.** Composant optoélectronique selon l'une quelconque des revendications 7 à 11, dans lequel une molécule organique selon la revendication 1 ou 2 forme conjointement avec un matériau fonctionnel un exciplexe.

**13.** Composant optoélectronique selon l'une quelconque des revendications 7 à 12, dans lequel l'émission est **caractérisée par** une fluorescence retardée activée thermiquement (TADF).

**14.** Composant optoélectronique selon l'une quelconque des revendications 7 à 13, dans lequel une molécule organique selon la revendication 1 ou 2 est utilisée en tant que couche de transport de charge.

**15.** Procédé pour la production d'un composant optoélectronique, dans lequel on utilise une molécule organique selon la revendication 1 ou 2.

**16.** Procédé selon la revendication 15, dans lequel on effectue la mise en oeuvre de la molécule organique par un procédé de dépôt sous vide en phase vapeur ou à partir d'une solution.

Figur 1

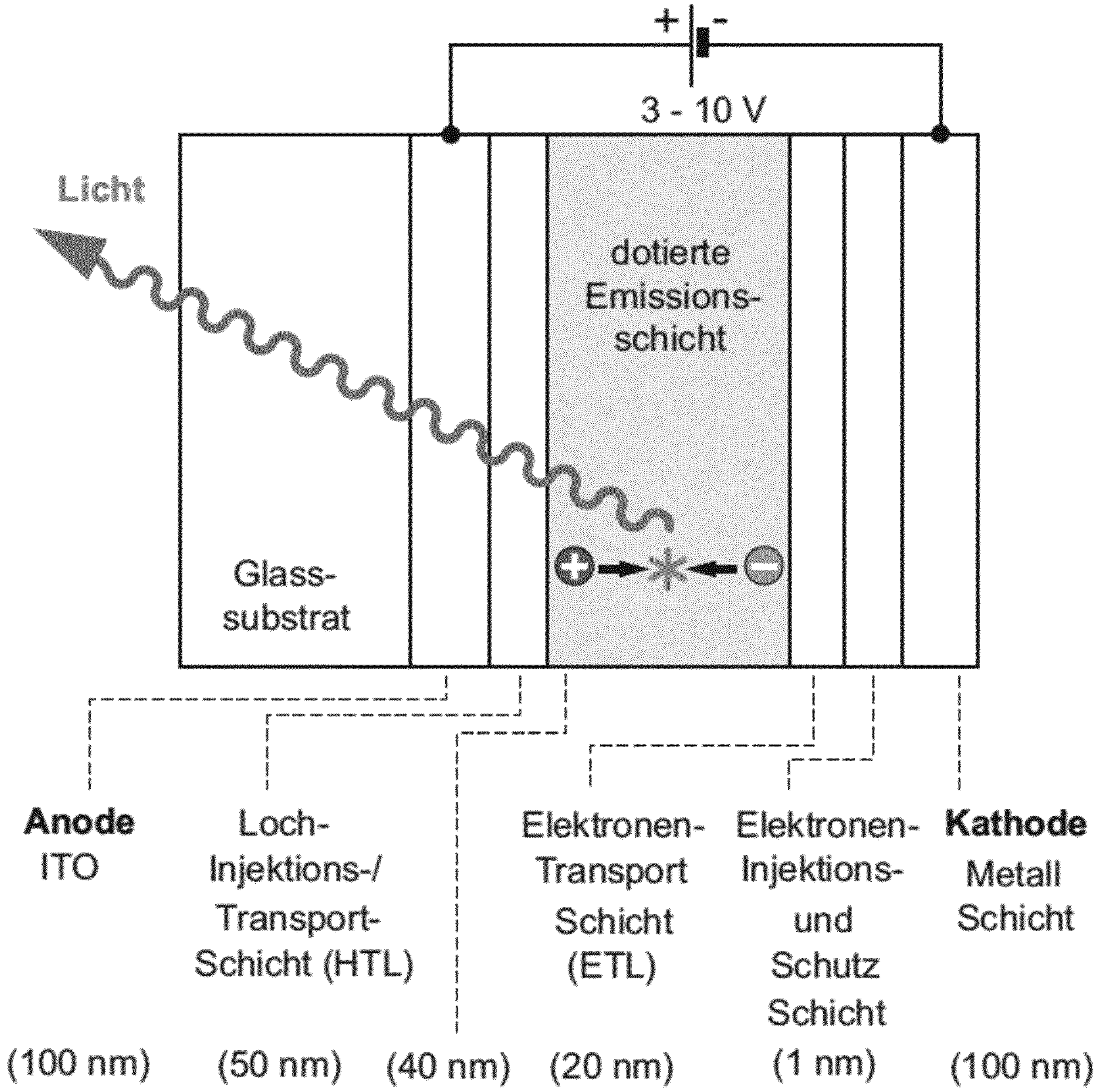
+
-
3 - 10 V
Licht
dotierte Emissions-schicht
Glass-substrat
Anode ITO (100 nm)
Loch-Injektions-/Transport-Schicht (HTL) (50 nm)
(40 nm)
Elektronen-Transport Schicht (ETL) (20 nm)
Elektronen-Injektions- und Schutz Schicht (1 nm)
Kathode Metall Schicht (100 nm)

Figur 2

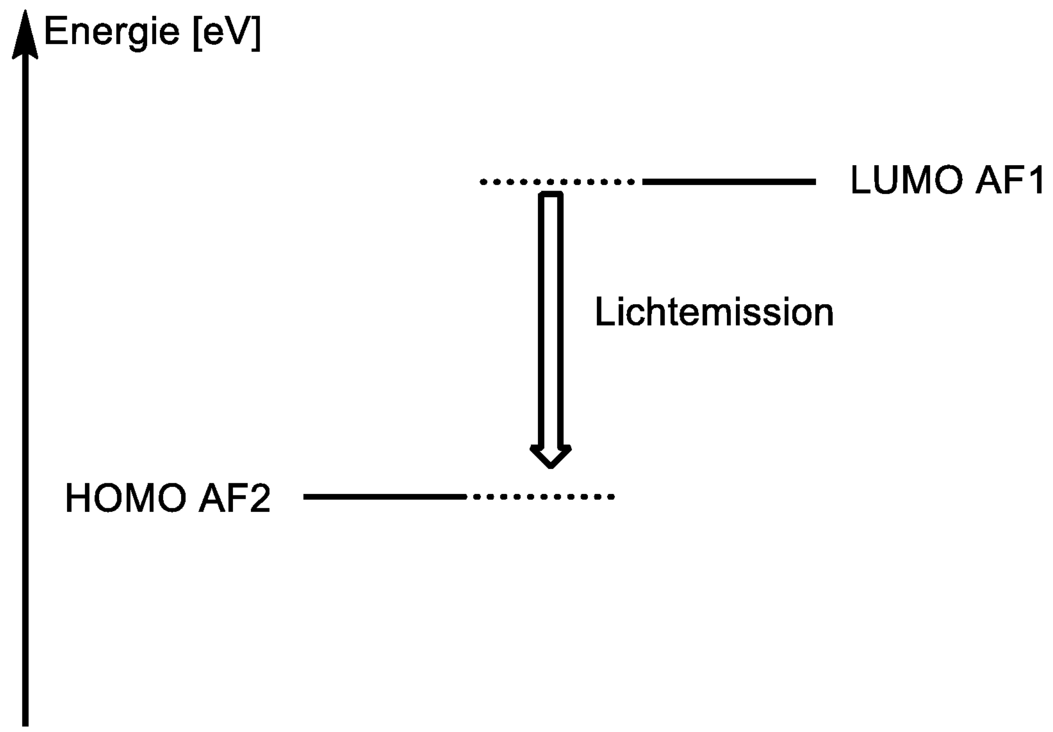

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur


- **H. YERSIN.** *Top. Curr. Chem.,* 2004, vol. 241, 1
- **H. YERSIN.** Highly Efficient OLEDs with Phosphorescent Materials. Wiley-VCH, 2008
- **TANG et al.** *Appl. Phys. Lett.,* 1987, vol. 51, 913
- **SIEHE DAZU AUCH H. YERSIN.** *Top. Curr. Chem.,* 2004, vol. 241, 1
- **M. A. BALDO ; D. F. O'BRIEN ; M. E. THOMPSON ; S. R. FORREST.** *Phys. Rev. B,* 1999, vol. 60, 14422
- **UOYAMA et al.** *Nature,* 2012, vol. 492, 234-238
- **BECKE, A. D.** *Phys. Rev. A,* 1988, vol. 38, 3098-3100
- **PERDEW, J. P.** *Phys. Rev. B,* 1986, vol. 33, 8822-8827
- **WEIGEND, F. ; AHLRICHS, R.** *Phys. Chem. Chem. Phys.,* 2005, vol. 7, 3297-3305
- **RAPPOPORT, D. ; FURCHE, F. J.** *Chem. Phys.,* 2010, vol. 133, 134105, , 1-134105, 11
- **HÄSER, M. ; AHLRICHS, R. J.** *Comput. Chem.,* 1989, vol. 10, 104-111
- **WEIGEND, F. ; HÄSER, M.** *Theor. Chem. Acc.,* 1997, vol. 97, 331-340
- **SIERKA, M. ; HOGEKAMP, A. ; AHLRICHS, R.** *J. Chem. Phys.,* 2003, vol. 118, 9136-9148
- **BECKE, A.D.** *J.Chem.Phys.,* 1993, vol. 98, 5648-5652
- **LEE, C ; YANG, W ; PARR, R.G.** *Phys. Rev. B,* 1988, vol. 37, 785-789
- **LEE, C ; YANG, W ; PARR, R.G.** *Phys. Rev. B,* 1988, vol. 37, 785-789
- **VOSKO, S. H. ; WILK, L. ; NUSAIR, M.** *Can. J. Phys.,* 1980, vol. 58, 1200-1211
- **STEPHENS, P. J. ; DEVLIN, F. J. ; CHABALOWSKI, C. F. ; FRISCH, M. J.** *J.Phys.Chem.,* 1994, vol. 98, 11623-11627
- *J. Chem. Phys.,* 2010, vol. 133, 134105, , 1-134105, 11